# EUROPEAN PATENT APPLICATION

(11) **EP 4 092 758 A1**
(43) Date of publication of application: **23.11.2022**
(21) Application number: 22174567.2
(22) Date of filing: 20.05.2022
(51) Int. Cl.: H01L 31/0224, H01L 31/0465, H01L 31/048, H01L 31/05, H01L 31/075, H01L 51/00, H01L 51/42

(54) **CELL ASSEMBLY AND METHOD FOR PREPARING CELL ASSEMBLY**

(30) Priority: 21.05.2021 CN 202110560006
(71) Applicant: Huawei Technologies Co., Ltd., Shenzhen, Guangdong 518129 (CN)
(72) Inventor: PENG, Yong, Wuhan (CN); WANG, Shuo, Shenzhen, 518129 (CN); FU, Shengquan, Wuhan (CN)
(74) Representative: Thun, Clemens

(57) **Abstract**

This application provides a cell assembly and a method for preparing a cell assembly. The cell assembly includes a first subcell, a second subcell adjacent to the first subcell, and a bottom electrode. Both the first subcell and the second subcell include a P-type layer and an N-type layer, and a light-harvesting layer located between the P-type layer and the N-type layer. The P-type layer of the first subcell is connected to the N-type layer of the second subcell by using the bottom electrode. A connection manner between subcells is provided. Compared with a current manner in which P1, P2, and P3 gaps are formed between subcells through cutting to implement interconnection, geometrical optical loss brought by interconnection between the subcells can be reduced.

## Description

### TECHNICAL FIELD

This application relates to the field of cell preparation, and in particular, to a cell assembly and a method for preparing a cell assembly.

### BACKGROUND

In recent years, new thin film solar cells, represented by perovskite and organic thin film solar cells, have made tremendous progress. Due to their advantages such as high efficiency, low costs, and a simple process, the new thin film solar cells become most potential substitutes for silicon-based solar cells. In terms of efficiency, since the perovskite solar cell obtained photoelectric conversion efficiency of 3.8% in 2009, in just over a decade, efficiency of the perovskite solar cell has exceeded 25.2%, close to a record 26.7% of efficiency of a crystalline silicon cell, and photoelectric conversion efficiency of the organic solar cell has also exceeded 17.4%.

However, at present, all highly-efficient new thin film solar cells are basically still at a stage of laboratory small-area element cell devices (or referred to as subcells). After an area of the cell device becomes larger, photoelectric conversion efficiency of the cell device decreases sharply. How to reduce photoelectric conversion loss in transition from a cell device to a large-area cell assembly becomes a problem that urgently needs to be resolved.

### SUMMARY

This application provides a cell assembly and a method for preparing a cell assembly, so that photoelectric conversion loss in transition from a subcell to a large-area cell assembly can be reduced.

According to a first aspect, a cell assembly is provided, including: a first subcell, a second subcell adjacent to the first subcell, and a bottom electrode. Both the first subcell and the second subcell include a P-type layer, an N-type layer, and a light-harvesting layer located between the P-type layer and the N-type layer. The P-type layer of the first subcell is connected to the N-type layer of the second subcell by using the bottom electrode.

That the P-type layer of the first subcell is connected to the N-type layer of the second subcell by using the bottom electrode may be understood as follows: The P-type layer of the first subcell is connected to the bottom electrode, and the N-type layer of the second subcell is also connected to the bottom electrode.

In addition, the P-type layer includes a P-type semiconductor material, the P-type semiconductor material is positively charged, the N-type layer includes an N-type semiconductor material, and the N-type semiconductor material is negatively charged. Therefore, that the P-type layer of the first subcell is electrically connected to the N-type layer of the second subcell by using the bottom electrode may alternatively be understood as follows: An anode of the first subcell is connected to a cathode of the second subcell, to implement a series connection between the two subcells. Compared with a current manner in which P1, P2, and P3 gaps are formed between subcells through cutting to implement interconnection, geometrical optical loss brought by interconnection between the subcells can be reduced.

In the cell assembly provided in this embodiment of this application, one of the first subcell and the second subcell is a P-I-N type subcell, and the other subcell is an N-I-P type subcell. The P-I-N type subcell indicates that a structure of the subcell is a P-I-N structure. To be specific, an intrinsic (intrinsic) semiconductor layer is inserted between a P-type semiconductor layer and an N-type semiconductor layer. The N-I-P type subcell indicates that a structure of the subcell is an N-I-P structure, opposite to the P-I-N structure.

It can be learned from the foregoing that, a manner of interconnection between the two subcells is that the P-type layer of one subcell is connected to the N-type layer of the other subcell by using the bottom electrode. Specifically, the first subcell and the second subcell are disposed on the bottom electrode, the P-type layer of the first subcell is in contact with the bottom electrode, and the N-type layer of the second subcell is in contact with the bottom electrode. When the electrode is used as a lower substrate, it can be obtained that, the first subcell is a P-I-N type subcell, and the second subcell is an N-I-P type subcell. When an end (for example, the following back electrode) away from the electrode is used as a lower substrate, it can be obtained that, the first subcell is an N-I-P type subcell, and the second subcell is a P-I-N type subcell.

In this embodiment of this application, which one of two adjacent subcells is a P-I-N type subcell and which one is an N-I-P type subcell is not limited. For example, the first subcell is a P-I-N type subcell, and the second subcell is an N-I-P type subcell. In another example, the first subcell is an N-I-P type subcell, and the second subcell is a P-I-N type subcell.

It should be noted that, the bottom electrode may also be understood as a part of a subcell. For example, a subcell includes a P-type layer, an N-type layer, a light-harvesting layer, and a bottom electrode. The bottom electrode of the first subcell and the bottom electrode of the second subcell are an integral structure.

For example, the bottom electrode is a transparent conducting layer, or in other words, the bottom electrode is a semitransparent conducting layer.

With reference to the first aspect, in some implementations of the first aspect, the first subcell further includes a first back electrode, and the second subcell further includes a second back electrode. The N-type layer of the first subcell is connected to the first back electrode, and the P-type layer of the second subcell is connected to the second back electrode.

In the cell assembly provided in this embodiment of this application, the back electrodes of the two subcells are arranged in an interdigitated shape (for example, the N-type layer of the first subcell is connected to the first back electrode, and the first back electrode is a negative back electrode; the P-type layer of the second subcell is connected to the second back electrode, and the second back electrode is a positive back electrode), to eliminate shading loss of a grid electrode in a conventional solar cell device.

With reference to the first aspect, in some implementations of the first aspect, there are a plurality of first subcells, a plurality of second subcells, and a plurality of bottom electrodes. One first subcell, one second subcell, and one bottom electrode are used to form one cell unit. At least one cell unit forms one cell group. There are a plurality of cell groups. The plurality of cell groups are connected in parallel.

The cell assembly provided in this embodiment of this application is formed through series-parallel hybrid connection, to alleviate impact of a particular subcell on overall output performance of the assembly due to a factor such as a local defect, or a damage, or shading, thereby improving reliability of the cell assembly. For example, when performance of a particular subcell becomes poor due to a factor such as a local defect, or a damage, or shading, but the subcell is connected in parallel to another subcell, performance of the another subcell is not affected when the performance of the subcell becomes poor. Therefore, reliability of the cell assembly can be improved.

It should be noted that, not all the cell groups included in the cell assembly are required to participate in parallel connection. For example, the cell assembly includes M cell groups, M-1 cell groups are connected in parallel, and the other cell group is used as a standby cell group.

With reference to the first aspect, in some implementations of the first aspect, that the plurality of cell groups are connected in parallel includes: A first back electrode on an outermost side of each cell group in the plurality of the cell groups is connected by using a second electrical conductor, and a second back electrode on the outermost side of each cell group in the plurality of cell groups is connected by using the second electrical conductor.

In the cell assembly provided in this embodiment of this application, connection between cell groups means that corresponding positive back electrodes are connected in parallel between the cell groups, to avoid contact resistance loss generated by direct contact between a metal back electrode and a bottom electrode through cutting in a conventional assembly, avoid leakage loss brought by direct contact between the metal back electrode and functional layers, and the like, thereby optimizing electrical loss of the conventional assembly.

With reference to the first aspect, in some implementations of the first aspect, the cell group includes a plurality of cell units. The second back electrode in one of two adjacent cell units in the plurality of cell units is connected to the first back electrode in the other cell unit by using a first electrical conductor.

In the cell assembly provided in this embodiment of this application, two subcells are connected in series to form one cell unit, and two cell units are connected in series. A manner of series connection is as follows: A negative back electrode of one cell unit is connected to a positive back electrode of the other cell unit. In other words, connection between cell units means that corresponding positive back electrodes are connected in series to negative back electrodes between the cell units, to avoid contact resistance loss generated by direct contact between a metal back electrode and a bottom electrode through cutting in a conventional assembly, avoid leakage loss brought by direct contact between the metal back electrode and functional layers, and the like, thereby optimizing electrical loss of the conventional assembly.

With reference to the first aspect, in some implementations of the first aspect, a first slot is provided between the first subcell and the second subcell, and the first slot is located between the first back electrode of the first subcell and the second back electrode of the second subcell, between the N-type layer of the first subcell and the P-type layer of the secondsubcell, between the P-type layer of the first subcell and the N-type layer of the second subcell, and between the light-harvesting layer of the first subcell and the light-harvesting layer of the second subcell; or
the light-harvesting layer included in the first subcell and the light-harvesting layer included in the second subcell are a same light-harvesting layer, a first slot is provided between the first subcell and the second subcell, and the first slot is located between the first back electrode of the first subcell and the second back electrode of the second subcell, between the N-type layer of the first subcell and the P-type layer of the secondsubcell, and between the P-type layer of the first subcell and the N-type layer of the second subcell.

Compared with a conventional assembly structure in which subcells are connected in series that is formed by three cutting processes: P1, P2, and P3, where a region in which the subcells are connected in series and that is formed by P1, P2, and P3 forms a dead zone or an invalid region, in the cell assembly provided in this embodiment of this application, there is only one gap between subcells that forms a dead zone, so that a dead zone of the assembly can be greatly reduced, thereby optimizing structural loss of the conventional assembly.

With reference to the first aspect, in some implementations of the first aspect, a second slot is provided between two adjacent cell units, and the second slot is located between a first back electrode of a third subcell and the second back electrode of the second subcell, between an N-type layer of the third subcell and the P-type layer of the second subcell, between a P-type layer of the third subcell and the N-type layer of the second subcell, between a light-harvesting layer of the third subcell and the light-harvesting layer of the second subcell, and between the first bottom electrode and a second bottom electrode; or
a second slot is provided between two adjacent cell units, and the second slot is located between a first back electrode of a third subcell and the second back electrode of the second subcell, between an N-type layer of the third subcell and the P-type layer of the second subcell, between a P-type layer of the third subcell and the N-type layer of the second subcell, and between the first bottom electrode and a second bottom electrode, and
the third subcell and the second subcell are subcells that are adjacent in two subcells separately included in the two adjacent cell units, and the first bottom electrode and the second bottom electrode are bottom electrodes separately included in the two adjacent cell units.

Compared with a conventional assembly structure in which subcells are connected in series that is formed by three cutting processes: P1, P2, and P3, in the cell assembly provided in this embodiment of this application, there is only one gap between the cell units that forms a dead zone, so that a dead zone of the assembly can be greatly reduced, thereby optimizing structural loss of the conventional assembly.

With reference to the first aspect, in some implementations of the first aspect, when the light-harvesting layer is made from single-crystal perovskite, adjacent subcells separately include two light-harvesting layers, and a slot is provided between the light-harvesting layers; or when the light-harvesting layer is made from polycrystalline perovskite, the light-harvesting layers of the adjacent subcells are an integral structure.

In the cell assembly provided in this embodiment of this application, the light-harvesting layer may be prepared by using a plurality of materials, to improve flexibility of the solution. For example, if the light-harvesting layer is made from polycrystalline perovskite, a transverse diffusion length of a carrier is small and is micron-scale. No slot needs to be provided between light-harvesting layers included in adjacent subcells. In another example, if the light-harvesting layer is made from single-crystal perovskite, the transverse diffusion length of the carrier is relatively large, and is dozens of microns or even a hundred of microns. A slot needs to be provided between light-harvesting layers included in adjacent subcells.

With reference to the first aspect, in some implementations of the first aspect, an insulating material is filled in the first slot and/or the second slot.

The insulating material may be filled in the slot provided between the subcells and/or the slot provided between the cell units, to avoid an electrical connection between layers, causing connection interference.

With reference to the first aspect, in some implementations of the first aspect, the insulating material includes at least one of the following: aluminum oxide Al₂O₃, silicon dioxide SiO₂, a ceramic material, polystyrene, polypropylene, epoxy plastic, polyester, polycarbonate, polytetrafluoroethylene, and polyimide.

There may be a plurality of choices for the insulating material, provided that insulation can be implemented, so that flexibility of the solution is improved.

With reference to the first aspect, in some implementations of the first aspect, the bottom electrode is made from at least one of the following materials: a transparent conductive oxide TCO, a conductive polymer, a metal nanowire, a metal mesh, graphene, a carbon nanotube, metal or an alloy, and a metal oxide.

There may be a plurality of choices for the material for preparing the bottom electrode, provided that a function of conducting electricity and transmitting light of the bottom electrode can be implemented, so that flexibility of the solution is improved.

With reference to the first aspect, in some implementations of the first aspect, a structure of the subcell includes a back electrode, functional layers, a bottom electrode, and a transparent substrate in sequence; or the structure of the subcell includes the bottom electrode, the functional layers, the back electrode, and the substrate in sequence. The functional layers include a P-type layer, an N-type layer, and a light-harvesting layer located between the P-type layer and the N-type layer. The substrate is made from at least one of the following materials: glass, metal, fiber fabric, polyimide PI, polyethylene terephthalate PET, polybutylene terephthalate PBT, polyethylene naphthalate PEN, polydimethyl siloxane PDMS, and PDMS derivatives. The transparent substrate is made from at least one of the following materials: PET, PEN, polyimide PI, PDMS, and glass.

In the cell assembly provided in this embodiment of this application, the structure of the subcell may be one of the foregoing two structures, to improve flexibility of the solution. There may be a plurality of choices for the material for preparing the substrate or the transparent substrate, to improve flexibility of the solution.

According to a second aspect, a method for preparing a cell assembly is provided. Method 1 includes: preparing a bottom electrode; alternately preparing a first P-type layer and a first N-type layer on the bottom electrode; and preparing light-harvesting layers on the first P-type layer and the first N-type layer, where the first P-type layer and the first N-type layer that are adjacent on the bottom electrode are connected by using the bottom electrode.

Alternatively, Method 2 includes: preparing light-harvesting layers; alternately preparing a first P-type layer and a first N-type layer on the light-harvesting layers; and preparing a bottom electrode on the first P-type layer and the first N-type layer, where the first P-type layer and the first N-type layer that are adjacent on the bottom electrode are connected by using the bottom electrode.

Specifically, one bottom electrode, one first P-type layer, and one light-harvesting layer are used to form one first subcell; one bottom electrode, one first N-type layer adjacent to the first P-type layer, and one light-harvesting layer are used to form one second subcell, and the bottom electrode of the first subcell and the bottom electrode of the second subcell are an integral structure.

In the cell assembly prepared by using the method for preparing a cell assembly provided in this embodiment of this application, a manner of interconnection between two subcells is that a P-type layer of one subcell is connected to an N-type layer of the other subcell by using the bottom electrode, to implement series connection between the two subcells. Compared with a current manner in which P1, P2, and P3 gaps are formed between subcells through cutting to implement interconnection, geometrical optical loss brought by interconnection between the subcells can be reduced.

With reference to the second aspect, in some implementations of the second aspect, corresponding to the foregoing Method 1, the method further includes: alternately preparing a second N-type layer and a second P-type layer on the light-harvesting layers; and preparing a first back electrode on the second N-type layer and preparing a second back electrode on the second P-type layer; or
corresponding to the foregoing Method 2, before the preparing light-harvesting layers, the method further includes: alternately preparing a first back electrode and a second back electrode; and preparing a second N-type layer on the first back electrode, and preparing a second P-type layer on the second back electrode.

The second N-type layer is connected to the first back electrode, and the second P-type layer is connected to the second back electrode. One second N-type layer and one first back electrode are used to form one first subcell. One second P-type layer adjacent to the second N-type layer and one second back electrode are used to form one second subcell.

In the cell assembly prepared by using the method for preparing a cell assembly provided in this embodiment of this application, back electrodes of two subcells are arranged in an interdigitated shape (for example, the N-type layer of the first subcell is connected to the first back electrode, and the first back electrode is a negative back electrode; the P-type layer of the second subcell is connected to the second back electrode, and the second back electrode is a positive back electrode), to eliminate shading loss of a grid electrode in a conventional solar cell device.

With reference to the second aspect, in some implementations of the second aspect, one first subcell, one second subcell, and one bottom electrode are used to form one cell unit. At least one cell unit forms one cell group. There are a plurality of cell groups. The method further includes: connecting a first back electrode on an outermost side of each cell group in the plurality of the cell groups by using a second electrical conductor, and connecting a second back electrode on the outermost side of each cell group in the plurality of cell groups by using the second electrical conductor.

In the cell assembly prepared by using the method for preparing a cell assembly provided in this embodiment of this application, connection between cell groups means that corresponding positive back electrodes are connected in parallel between the cell groups, to avoid contact resistance loss generated by direct contact between a metal back electrode and a bottom electrode through cutting in a conventional assembly, avoid leakage loss brought by direct contact between the metal back electrode and functional layers, and the like, thereby optimizing electrical loss of the conventional assembly.

With reference to the second aspect, in some implementations of the second aspect, the cell group includes a plurality of cell units. The method further includes: connecting the second back electrode in one of two adjacent cell units in the plurality of cell units to the first back electrode in the other cell unit by using a first electrical conductor.

In the cell assembly prepared by using the method for preparing a cell assembly provided in this embodiment of this application, two cell units are connected in series, and a manner of series connection is as follows: A negative back electrode of one cell unit is connected to a positive back electrode of the other cell unit. In other words, connection between cell units means that corresponding positive back electrodes are connected in series to negative back electrodes between the cell units, to avoid contact resistance loss generated by direct contact between a metal back electrode and a bottom electrode through cutting in a conventional assembly, avoid leakage loss brought by direct contact between the metal back electrode and functional layers, and the like, thereby optimizing electrical loss of the conventional assembly.

With reference to the second aspect, in some implementations of the second aspect, the method further includes:
providing a first slot between the first back electrode of the first subcell and the second back electrode of the second subcell, between the N-type layer of the first subcell and the P-type layer of the second subcell, between the P-type layer of the first subcell and the N-type layer of the second subcell, and between the light-harvesting layer of the first subcell and the light-harvesting layer of the second subcell; or
the light-harvesting layer of the first subcell and the light-harvesting layer of the second subcell are an integral structure, and the method further includes:
   providing a first slot between the first back electrode of the first subcell and the second back electrode of the second subcell, between the N-type layer of the first subcell and the P-type layer of the second subcell, and between the P-type layer of the first subcell and the N-type layer of the second subcell.

Compared with a conventional assembly structure in which subcells are connected in series and that is formed by three cutting processes: P1, P2, and P3, where a region in which the subcells are connected in series and that is formed by P1, P2, and P3 forms a dead zone or an invalid region, in the cell assembly prepared by using the method for preparing a cell assembly provided in this embodiment of this application, there is only one gap between subcells that forms a dead zone, so that a dead zone of the assembly can be greatly reduced, thereby optimizing structural loss of the conventional assembly.

With reference to the second aspect, in some implementations of the second aspect, the method further includes: providing a second slot between a first back electrode of a third subcell and the second back electrode of the second subcell, between an N-type layer of the third subcell and the P-type layer of the second subcell, between a P-type layer of the third subcell and the N-type layer of the second subcell, between a light-harvesting layer of the third subcell and the light-harvesting layer of the second subcell, and between the first bottom electrode and a second bottom electrode.

Alternatively, light-harvesting layers of two adjacent cell units are an integral structure, and the method further includes:
providing a second slot between a first back electrode of a third subcell and the second back electrode of the second subcell, an N-type layer of the third subcell and the P-type layer of the second subcell, between a P-type layer of the third subcell and the N-type layer of the second subcell, and between the first bottom electrode and a second bottom electrode, and
the third subcell and the second subcell are subcells that are adjacent in two subcells separately included in the two adjacent cell units, and the first bottom electrode and the second bottom electrode are bottom electrodes separately included in the two adjacent cell units.

Compared with a conventional assembly structure in which subcells are connected in series and that is formed by three cutting processes: P1, P2, and P3, in the cell assembly prepared by using the method for preparing a cell assembly provided in this embodiment of this application, there is only one gap between the cell units that forms a dead zone, so that a dead zone of the assembly can be greatly reduced, thereby optimizing structural loss of the conventional assembly.

With reference to the second aspect, in some implementations of the second aspect, the method further includes: filling an insulating material in the first slot and/or the second slot.

The insulating material may be filled in the slot provided between the subcells and/or the slot provided between the cell units, to avoid an electrical connection between layers, causing connection interference.

According to a third aspect, an electronic device is provided, including a power consumption module and the cell assembly shown in the first aspect, or including a cell assembly prepared by using the preparation method in the second aspect. The cell assembly is used to supply power to the power consumption module.

For example, the electronic device may further be a handheld device, a vehicle-mounted device, a wearable device, a computing device, a terminal in various forms, a mobile station (mobile station, MS), a terminal (terminal), a software client, or the like. For example, the electronic device may be a water meter, an electricity meter, a sensor, or the like.

As an example rather than a limitation, in embodiments of this application, the wearable device may also be referred to as a wearable smart device, and is a general term for daily wearable devices that are smartly designed and developed by using wearable technologies, such as glasses, gloves, watches, apparels, and shoes. The wearable device is a portable device that can be directly worn on the body or integrated into the clothing or an accessory of a user. The wearable device is not merely a hardware device, but further implements a powerful function through software support, data exchange, and cloud-based interaction. In a broad sense, wearable intelligent devices include a device that provides a complete function, has a large size, and can implement all or some functions without relying on a smartphone, for example, a smartwatch or smart glasses; and include a device that focuses only on a specific type of application function and needs to be used in combination with another device such as a smartphone, for example, various smart bands and smart jewelry used for vital sign monitoring.

For example, the electronic device may be smart glasses. The cell assembly shown in the first aspect is configured to constitute a lens of the smart glasses, and the power consumption module is disposed on a frame and/or an arm of the smart glasses.

The power consumption module may be a module that needs to consume power, for example, a processing module, an input/output module, or a display module of the smart glasses.

### BRIEF DESCRIPTION OF DRAWINGS

FIG. 1 is a schematic diagram of a structure of a solar cell device;
FIG. 2 is a schematic diagram of a structure of a solar cell assembly;
FIG. 3(a) and FIG. 3(b) are schematic diagrams of a structure of a cell assembly according to an embodiment of this application;
FIG. 4 is a schematic diagram of a connection manner between cell units according to an embodiment of this application;
FIG. 5 is a schematic diagram of a connection manner between cell groups according to an embodiment of this application;
FIG. 6 is a schematic diagram of a connection manner between cell strings according to an embodiment of this application;
FIG. 7(a) and FIG. 7(b) are schematic diagrams of a structure of a subcell according to an embodiment of this application;
FIG. 8(a) and FIG. 8(b) show a structural form of two cell units according to an embodiment of this application;
FIG. 9(a) and FIG. 9(b) are schematic diagrams of a structure of another subcell according to an embodiment of this application;
FIG. 10(a) and FIG. 10(b) show another structural form of two cell units according to an embodiment of this application;
FIG. 11(a) and FIG. 11(b) are schematic diagrams of a slotting manner according to an embodiment of this application;
FIG. 12(a) and FIG. 12(b) are schematic diagrams of another slotting manner according to an embodiment of this application;
FIG. 13 is a schematic diagram of a cross-sectional view of a cell assembly according to an embodiment of this application;
FIG. 14 is a schematic diagram of a top view of a cell assembly according to an embodiment of this application;
FIG. 15 is a schematic diagram of a cross-sectional view of another cell assembly according to an embodiment of this application;
FIG. 16 is a schematic diagram of a top view of another cell assembly according to an embodiment of this application;
FIG. 17 is a schematic diagram of a cross-sectional view of still another cell assembly according to an embodiment of this application;
FIG. 18 is a schematic diagram of a cross-sectional view of still another cell assembly according to an embodiment of this application;
FIG. 19 is a schematic block diagram of an electronic device according to an embodiment of this application;
FIG. 20 is a schematic flowchart of a method for preparing a cell assembly according to an embodiment of this application;
FIG. 21A to FIG. 21C are a schematic flowchart of preparing a cell assembly according to an embodiment of this application;
FIG. 22 is a schematic flowchart of another method for preparing a cell assembly according to an embodiment of this application;
FIG. 23A to FIG. 23C are a schematic flowchart of preparing another cell assembly according to an embodiment of this application;
FIG. 24 is a schematic diagram of a cross section of a perovskite solar cell assembly according to an embodiment of this application;
FIG. 25 is a top view of a perovskite solar cell assembly according to an embodiment of this application;
FIG. 26 is a schematic diagram of an apparatus 2600 for preparing a cell assembly according to this application; and
FIG. 27 is a schematic diagram of a structure of an apparatus 2700 for preparing a cell assembly according to an embodiment of this application.

### DESCRIPTION OF EMBODIMENTS

The following describes technical solutions of this application with reference to accompanying drawings.

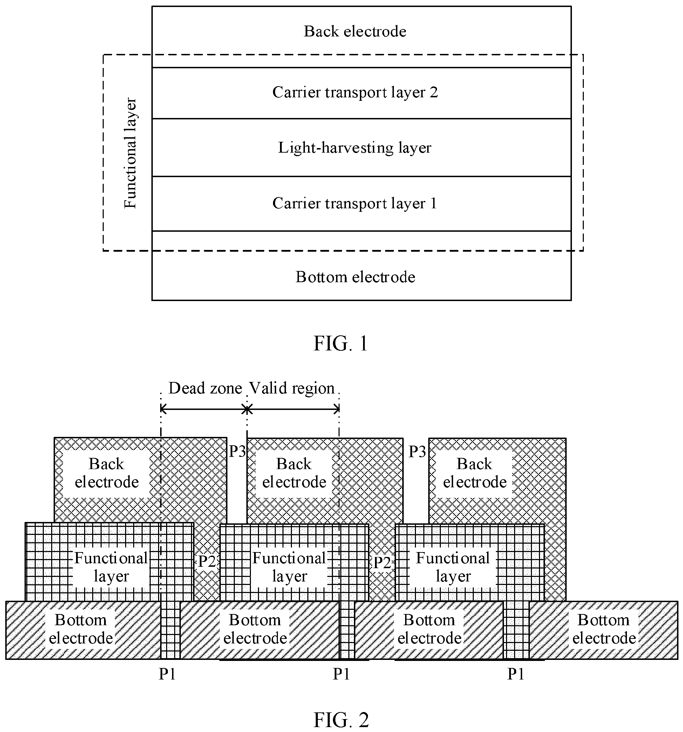

A cell preparation method provided in this application can implement preparation of a large-area solar cell assembly. A general structure of a solar cell is shown in FIG. 1. FIG. 1 is a schematic diagram of a structure of a solar cell device. It can be seen from FIG. 1 that the solar cell device includes:
a bottom electrode, functional layers, and a back electrode.

Specifically, the bottom electrode is a transparent conducting electrode (or referred to as a transparent conducting layer), and the functional layers include a carrier transport layer 1, a light-harvesting layer, and a carrier transport layer 2. The carrier transport layers are an electron transport layer (N-type layer) and a hole transport layer (P-type layer), incident light is incident from the bottom electrode to the light-harvesting layer, a material of the light-harvesting layer absorbs photons and is excited to generate electron hole pairs, and the carrier transport layer 1 and the carrier transport layer 2 separately extract electrons or holes for transmission to the bottom electrode and the back electrode.

Further, P1, P2, P3 slotting is performed on the solar cell device, to form a cell assembly form in which subcells are connected in series. FIG. 2 is a schematic diagram of a structure of a solar cell assembly. It can be seen from FIG. 2 that:
photocurrent cannot be generated in an interconnection region of two adjacent cell devices (a length between P1 and P3 shown in FIG. 2), and therefore, the interconnection region is referred to as a "dead zone", and existence of the "dead zone" brings geometrical loss. A part without a slotted region in the cell device is referred to as a "valid region".

Ideally, cutting widths of P1, P2 and P3 should be minimized to reduce geometrical optical loss.

In addition, the cell assembly structure shown in FIG. 2 also has a contact resistance problem. For example, there may be behaviors such as false wiring and voids between the back electrode and the bottom electrode due to impact of material contact potential energy, surface conditions, and the like, resulting in relatively large contact resistance. In another example, a current leakage problem is caused by direct contact between a metal electrode and the N-type layer or the P-type layer material. In another example, the large-area cell assembly has a relatively high requirement on sheet resistance of the bottom electrode, and the cost of the bottom electrode increases.

Further, in the design of the cell assembly structure in which cell devices are purely connected in series, performance of the cell assembly is strongly dependent on performance of a single cell device, and performance of the single cell device (for example, local defect density, damage, and shading) directly affects performance of the entire cell assembly.

The "cell device" in the embodiments of this application refers to a single cell unit, including the bottom electrode, the functional layers, and the back electrode. The "cell assembly" refers to a cell structure in which a plurality of cell units are combined through connection (for example, series and/or parallel connection) to meet specific requirements (for example, power, voltage or current requirements).

It should be understood that names of structures are not limited in the embodiments of this application. For example, the foregoing "cell device" and "cell assembly" are merely examples, and do not constitute any limitation on the protection scope of this application. The "cell device" may be referred to as a "subcell", a "cell", a "single cell", or the like. The "cell assembly" may be referred to as a "cell set" or a "cell pack", or the like. This is not described herein by using examples one by one.

It should be further understood that a method for preparing a cell assembly provided in the embodiments of this application is not only used for preparing a solar cell assembly, but may also be used for preparing another type of cell assembly. The foregoing solar cell device and the solar cell assembly including the solar cell device are merely examples, and do not constitute any limitation on the protection scope of this application.

To resolve the problems existing in the current cell assembly structure formed by connecting cell devices, this application provides a cell assembly and a method for preparing a cell assembly. By avoiding P1, P2, and P3 slotting on the solar cell device, photoelectric conversion loss in transition from an element cell device to the large-area assembly can be reduced.

For ease of understanding the embodiments of this application, several basic concepts in the embodiments of this application are first briefly described. It should be understood that, the basic concepts described in the following are briefly described by using disclosure in the current related technology as an example, and specific names are not limited in this application.

### 1. Interdigitated back contact (interdigitated back contact, IBC).

An IBC silicon solar cell overcomes shading loss of a grid electrode in a conventional silicon solar cell and has excellent photoelectric conversion efficiency. Specifically, an anode and a cathode of the IBC silicon solar cell are both located on a back surface of the cell device and are arranged in an interdigitated shape, to eliminate shading loss of a grid electrode in a conventional solar cell device.

### 2. P-I-N structure.

An intrinsic (intrinsic) semiconductor layer is inserted between a P-type semiconductor layer and an N-type semiconductor layer. Sensitivity is higher than that of a general P-N structure.

An N-type semiconductor is obtained by doping donor impurities into a semiconductor, and a P-type semiconductor is obtained by doping acceptor impurities into the semiconductor. Products including the P-type semiconductor or N-type semiconductor include resistive elements such as thermistors and varistors. A most common single junction semiconductor element including a combination of P-type and N-type semiconductors is a diode.

In addition, an intrinsic semiconductor (intrinsic semiconductor) is a pure semiconductor that contains no impurity and has no lattice defect, and generally refers to a pure semiconductor whose conductivity is mainly determined by intrinsic excitation of the material. Typical intrinsic semiconductors include silicon (Si), germanium (Ge), and gallium arsenide (GaAs).

### 3. N-I-P structure.

The N-I-P structure is opposite to the P-I-N structure. An intrinsic semiconductor layer is inserted between the N-type semiconductor layer and the P-type semiconductor layer.

In addition, for ease of understanding the embodiments of this application, the following description is provided.

"First", "second", and various numerical numbers (for example, "#1", and "#2") shown in this application are merely for ease of description, and are used to distinguish between objects, but are not intended to limit the scope of embodiments of this application. It should be understood that the objects described in this way are interchangeable in a proper circumstance, so that a solution other than embodiments of this application can be described.

The embodiments shown below do not specifically limit a specific structure of an execution body of the method provided in the embodiments of this application, provided that a cell assembly can be prepared based on the method provided in the embodiments of this application by running programs that record code of the method provided in the embodiments of this application. For example, the execution body of the method provided in the embodiments of this application may be a device for preparing the cell assembly, or functional modules that can invoke programs and execute the programs in the device for preparing the cell assembly.

Without loss of generality, the cell assembly and the method for preparing a cell assembly provided in the embodiments of this application are described in detail below by using an example in which the device for preparing the cell assembly prepares the cell assembly.

Specifically, this application provides a cell assembly. The cell assembly includes:
a first subcell, a second subcell adjacent to the first subcell, and a bottom electrode, where both the first subcell and the second subcell include a P-type layer, an N-type layer, and a light-harvesting layer located between the P-type layer and the N-type layer, and the P-type layer of the first subcell is connected to the N-type layer of the second subcell by using the bottom electrode.

Specifically, the cell assembly in this embodiment of this application includes at least two subcells connected in series, and a manner of series connection between the subcells is as follows: Bottom electrodes of the two subcells are an integral structure, and a P-type layer of one subcell is connected to an N-type layer of the other subcell by using the bottom electrode.

Compared with a manner in which interconnection is implemented by forming P1, P2 and P3 gaps through cutting between the subcells, as shown in FIG. 2, when series connection is performed in this manner of series connection, geometrical optical loss brought by interconnection between the subcells can be reduced.

It can be learned from the foregoing description that, one of two adjacent subcells is a P-I-N type subcell, and the other subcell is an N-I-P type subcell. For example, the first subcell is a P-I-N type subcell, and the second subcell is an N-I-P type subcell. In another example, the first subcell is an N-I-P type subcell, and the second subcell is a P-I-N type subcell.

Further, the first subcell further includes a first back electrode, and the second subcell further includes a second back electrode. The N-type layer of the first subcell is connected to the first back electrode, and the P-type layer of the second subcell is connected to the second back electrode.

Specifically, in this embodiment of this application, that back electrodes of two adjacent subcells in the cell assembly are arranged in an interdigitated shape may be understood as follows: A back electrode of one of the two subcells connected in series is a negative back electrode, and a back electrode of the other subcell is a positive back electrode (for example, the N-type layer of the first subcell is connected to the first back electrode, and the first back electrode is a negative back electrode; the P-type layer of the second subcell is connected to the second back electrode, and the second back electrode is a positive back electrode), to eliminate shading loss of a grid electrode in a conventional solar cell device.

In addition, it should be noted that, the subcell further includes a substrate. When the substrate is connected to the bottom electrode, the substrate should be a transparent substrate, through which sunlight can pass through. When the substrate is connected to the back electrode, the substrate may not be transparent.

For example, the foregoing bottom electrode is a transparent conducting layer, or is referred to as a transparent conducting electrode.

For example, the foregoing bottom electrode is a semitransparent conducting layer, or is referred to as a semitransparent conducting electrode.

For ease of description, the following provides description by using an example in which the bottom electrode is a transparent conducting layer.

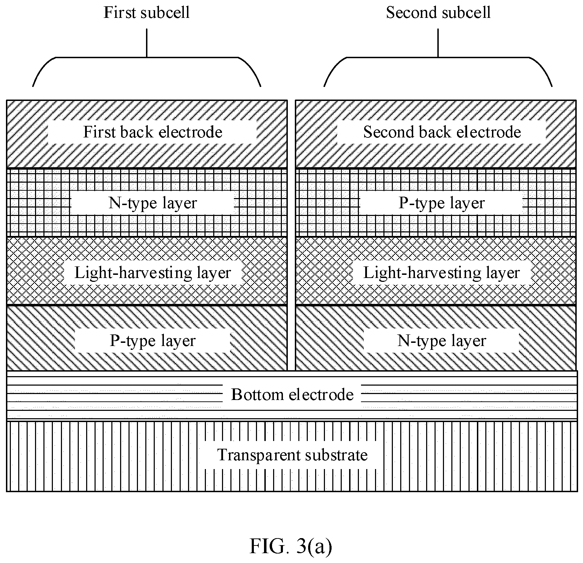

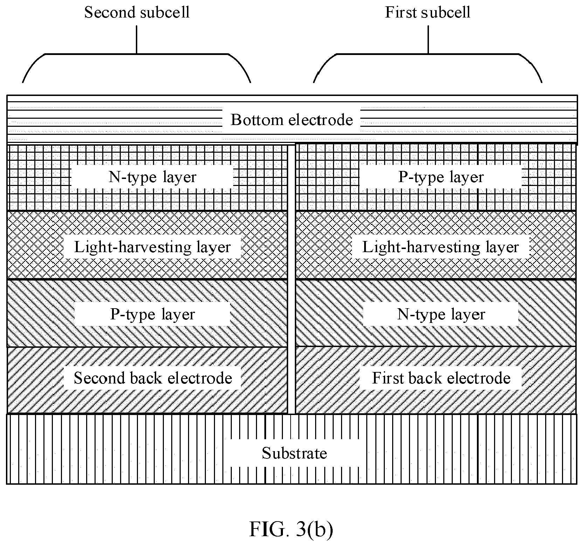

For ease of understanding, a structural form of the cell assembly is described with reference to FIG. 3(a) and FIG. 3(b). FIG. 3(a) and FIG. 3(b) are schematic diagrams of a structure of a cell assembly according to an embodiment of this application.

It can be seen from FIG. 3(a) and FIG. 3(b) that, the cell assembly includes a first subcell and a second subcell. A bottom electrode of the first subcell and a bottom electrode of the second subcell are an integral structure. A transparent substrate of the subcell shown in FIG. 3(a) is connected to the bottom electrode, and a substrate of the subcell shown in FIG. 3(b) is connected to a back electrode.

It should be understood that, FIG. 3(a) and FIG. 3(b) are merely examples, and do not constitute any limitation on the protection scope of this application. The cell assembly in this embodiment of this application may include 2N subcells, and N is a positive integer. A manner of series connection between every two adjacent subcells (or in other words, N pairs of subcells, for example, the first subcell and the second subcell are adjacent subcells, and the third subcell and the fourth subcell are adjacent subcells ...) is the same as a manner of series connection between the first subcell and the second subcell shown in FIG. 3(a) and FIG. 3(b). Details are not described herein again.

For example, there are a plurality of first subcells, a plurality of second subcells, and a plurality of bottom electrodes. One first subcell, one second subcell, and one bottom electrode are used to form one cell unit (for example, FIG. 3(a) or FIG. 3(b) shows one cell unit).

For example, at least one cell unit forms one cell group. There are a plurality of cell groups. The plurality of cell groups are connected in parallel. That the plurality of cell groups are connected in parallel includes: A first back electrode on an outermost side of each cell group in the plurality of the cell groups is connected by using a second electrical conductor, and a second back electrode on the outermost side of each cell group in the plurality of cell groups is connected by using the second electrical conductor.

Further, the cell group includes a plurality of cell units. The second back electrode in one of two adjacent cell units in the plurality of cell units is connected to the first back electrode in the other cell unit by using a first electrical conductor.

When the foregoing cell assembly includes a cell group, it may be understood that, the cell assembly includes at least one cell string.

The cell string includes one or more cell groups. The plurality of cell groups are connected in parallel. The cell group includes at least one cell unit or a plurality of cell units. The plurality of cell units are connected in series. The cell unit includes two subcells. The two subcells are connected in series. The two subcells are a P-I-N type subcell and an N-I-P type subcell. Back electrodes of the two subcells are a positive back electrode and a negative back electrode. It may be understood that, the back electrodes included in the cell unit are two back electrodes that are alternately positive and negative.

For example, the cell assembly includes K (K≥1) cell strings connected in series and/or in parallel. Each cell string in the K cell strings includes M (M≥1) cell groups connected in parallel. Each cell group in the M cell groups includes N (N≥1) cell units connected in series. Each cell unit in the N cell units includes two subcells connected in series.

It should be noted that, that the cell units are connected in series in this embodiment of this application means that the cell units in the cell group are connected in series. If each cell group includes only one cell unit, because the cell groups are connected in parallel, the cell units are connected in parallel.

Specifically, that a plurality of cell units in the cell group are connected in series includes: A positive back electrode of a first cell unit is connected to a negative back electrode of a second cell unit by using a first electrical conductor (or in other words, the negative back electrode of the first cell unit is connected to the positive back electrode of the second cell unit by using the first electrical conductor), and the first cell unit and the second cell unit are two adjacent cell units in the plurality of cell units.

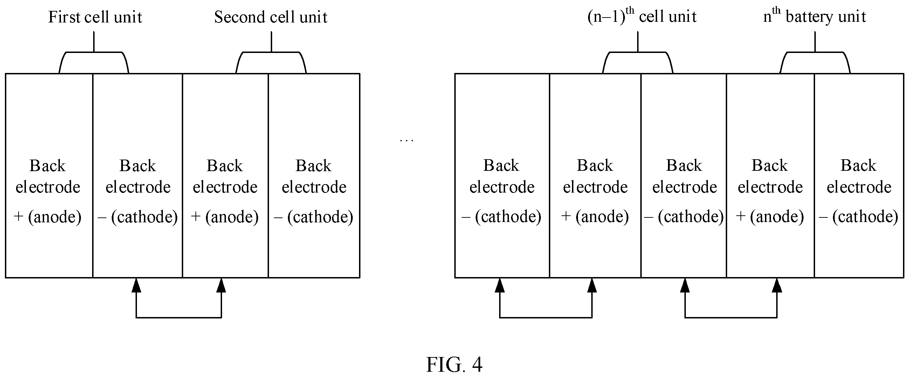

For example, it can be learned from the foregoing that, there are N cell units, the N cell units are arranged in sequence (for example, the first cell unit, the second cell unit, ..., and the Nth cell unit), and a manner of connection between two adjacent cell units is as follows: The positive back electrode (for example, a back electrode+ (anode) shown in FIG. 4) of one cell unit is connected to the negative back electrode (for example, a back electrode- (cathode) shown in FIG. 4) of the other cell unit.

For ease of understanding, a manner of series connection between the N cell units is described with reference to FIG. 4. FIG. 4 is a schematic diagram of a connection manner between cell units according to an embodiment of this application.

It should be understood that, FIG. 4 describes a possible connection manner between the cell units in the cell group only by using an example, and does not constitute any limitation on the protection scope of this application. The N cell units in the cell group may alternatively be connected in series in another form. The N cell units in this application only need to be connected in a form of series connection. A specific connection sequence is not limited.

For example, a first back electrode of a first cell unit is connected to a second back electrode of a second cell unit by using a first electrical conductor, and a first back electrode of a third cell unit is connected to a second back electrode of a fourth cell unit by using the first electrical conductor; a first cell group includes the first cell unit and the second cell unit, and a second cell group includes the third cell unit and the fourth cell unit. That the plurality of cell groups are connected in parallel includes:

A second back electrode of the first cell unit is connected to a second back electrode of the third cell unit by using a second electrical conductor, and the first back electrode of the second cell unit is connected to the first back electrode of the fourth cell unit by using the second electrical conductor.

The first cell group and the second cell group are any two cell groups in the plurality of cell groups.

The first back electrode is a positive back electrode, and the second back electrode is a negative back electrode, or the first back electrode is a negative back electrode, and the second back electrode is a positive back electrode.

For example, the positive back electrode of the first cell unit is connected to the positive back electrode of the third cell unit by using the second electrical conductor, and the negative back electrode of the second cell unit is connected to the negative back electrode of the fourth cell unit by using the second electrical conductor (for example, the negative back electrode of the first cell unit in the first cell group is connected in series to the positive back electrode of the second cell unit by using the first electrical conductor, and the negative back electrode of the third cell unit in the second cell group is connected in series to the positive back electrode of the fourth cell unit by using the first electrical conductor).

In another example, the negative back electrode of the first cell unit is connected to the negative back electrode of the third cell unit by using the second electrical conductor, and the positive back electrode of the second cell unit is connected to the positive back electrode of the fourth cell unit by using the second electrical conductor (for example, the positive back electrode of the first cell unit in the first cell group is connected in series to the negative back electrode of the second cell unit by using the first electrical conductor, and the positive back electrode of the third cell unit in the second cell group is connected in series to the negative back electrode of the fourth cell unit by using the first electrical conductor).

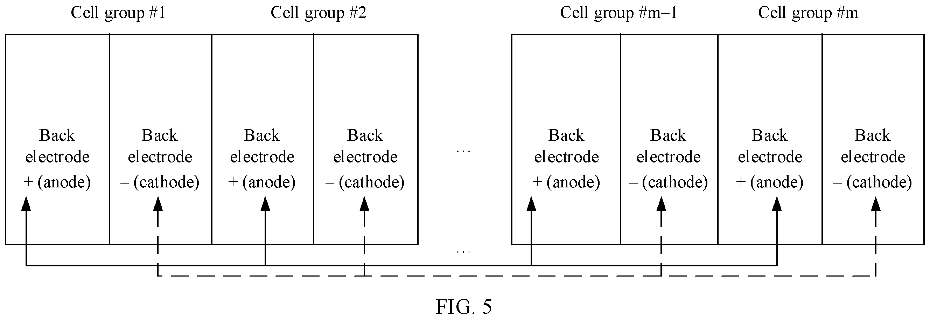

For example, it can be learned from the foregoing that, there are M cell groups, and a manner of connection between any two cell groups in the M cell groups is as follows: A positive back electrode (for example, a back electrode+ (anode) shown in FIG. 5) of one cell group is connected to a positive back electrode (for example, a back electrode+ (anode) shown in FIG. 5) of the other cell group, and a negative back electrode (for example, a back electrode- (cathode) shown in FIG. 5) of one cell group is connected to a negative back electrode (for example, a back electrode- (cathode) shown in FIG. 5) of the other cell group.

For ease of understanding, a manner of parallel connection between the M cell groups (for example, a cell group #1, a cell group #2, ..., a cell group #m-1, and a cell group #m shown in FIG. 5) is described with reference to FIG. 5. FIG. 5 is a schematic diagram of a connection manner between cell groups according to an embodiment of this application.

It should be understood that, FIG. 5 describes a possible connection manner between the cell groups only by using an example, and does not constitute any limitation on the protection scope of this application. The M cell groups may alternatively be connected in parallel in another form. The M cell groups in this application only need to be connected in a form of parallel connection. A specific connection sequence is not limited.

Specifically, that a plurality of cell strings are connected in series and/or in parallel includes: A first cell string is connected in series or in parallel to a second cell string, and the second cell string is connected in series to in parallel to a third cell string.

For example, it can be learned from the foregoing that, there are K cell strings, and any two cell strings in the K cell strings may be connected in a form of series connection or parallel connection.

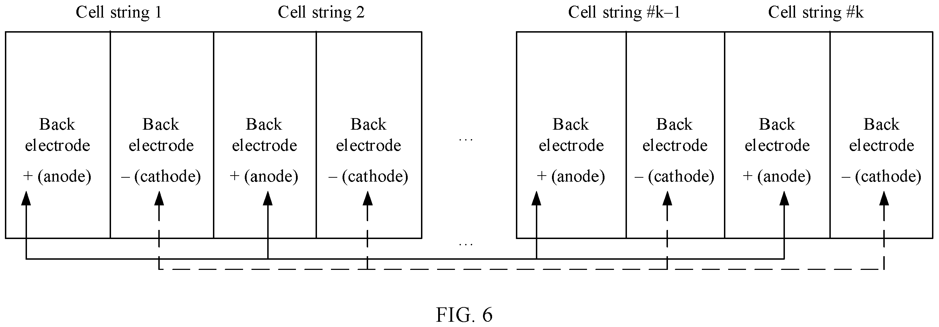

For ease of understanding, a manner of connection between the K cell strings (for example, a cell string #1, a cell string #2, ..., a cell string #k-1, and a cell string #k shown in FIG. 6) is described with reference to FIG. 6.

FIG. 6 is a schematic diagram of a connection manner between cell strings according to an embodiment of this application.

It should be understood that, FIG. 6 describes a possible connection manner between the cell strings only by using an example, and does not constitute any limitation on the protection scope of this application. The K cell strings may alternatively be connected in series and/or in parallel in another form. Description is not provided herein by using examples one by one.

For a distinguishing purpose, electrical conductors configured to connect to different back electrodes may be distinguished by using "first", "second", "third", and the like.

For example, the electrical conductor in this embodiment of this application includes at least one of the following conducting structures:
a conducting column, a conducting wire, or a conducting sheet.

For example, the electrical conductor in this embodiment of this application is formed in any one of the following manners:
strip welding, evaporation, or magnetron sputtering.

In the cell assembly of a type of series-parallel hybrid connection provided in this embodiment of this application, all the subcells are not connected purely in a manner of series connection (subcells included in different cell units are connected in parallel), to alleviate impact of a particular subcell on overall output performance of the cell assembly due to a factor such as a local defect, or a damage, or shading, thereby improving reliability of the cell assembly. For example, one subcell included in a particular cell unit is damaged and cannot work, but the subcell is connected in parallel to a subcell included in another cell unit in the cell assembly, and impact on performance of the another cell unit is small, so that impact on the overall output performance of the cell assembly is small.

In a possible implementation, the first cell unit includes a first subcell and a second subcell, the second cell unit includes a third subcell and a fourth subcell, one of the first subcell and the second subcell is a P-I-N type subcell and the other is an N-I-P type subcell, and one of the third subcell and the fourth subcell is a P-I-N type subcell and the other is an N-I-P type subcell.

For example, the first subcell is an N-I-P type subcell, and the second subcell is a P-I-N type subcell, or the second subcell is an N-I-P type subcell, and the first subcell is a P-I-N type subcell.

In another example, the third subcell is an N-I-P type subcell, and the fourth subcell is a P-I-N type subcell, or the fourth subcell is an N-I-P type subcell, and the third subcell is a P-I-N type subcell.

A structure of the subcell in this embodiment of this application includes the following two possibilities:

In a first possibility, the subcell includes a transparent substrate, a transparent conducting layer, functional layers, and a back electrode, and the functional layers include an N-type layer, a light-harvesting layer, and a P-type layer.

The transparent substrate, the transparent conducting layer, the functional layers, and the back electrode are arranged in a bottom-to-top sequence, and the N-type layer, the light-harvesting layer, and the P-type layer are arranged in a bottom-to-top sequence or in a top-to-bottom sequence.

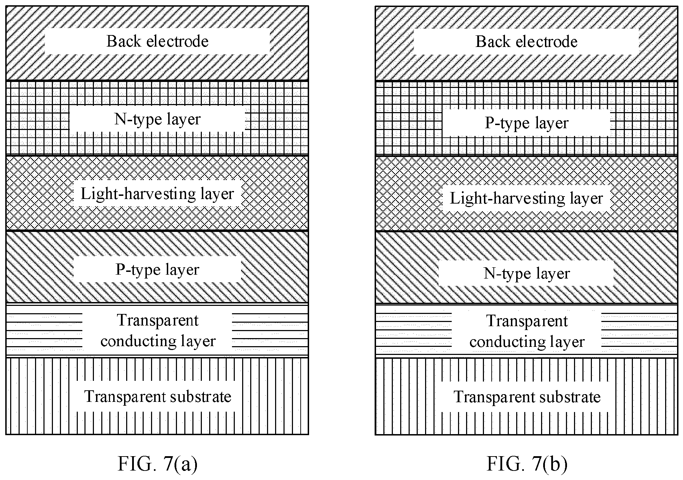

For ease of understanding, a structural form of the subcell in the first possibility is described with reference to FIG. 7(a) and FIG. 7(b). FIG. 7(a) and FIG. 7(b) are schematic diagrams of a structure of a subcell according to an embodiment of this application.

It can be seen from FIG. 7(a) and FIG. 7(b) that, the N-type layer, the light-harvesting layer, and the P-type layer shown in FIG. 7(a) are arranged in a top-to-bottom sequence, and the N-type layer, the light-harvesting layer, and the P-type layer shown in FIG. 7(b) are arranged in a bottom-to-top sequence.

For example, the structure of the first subcell and the second subcell that are included in the first cell unit and the structure of the third subcell and the fourth subcell that are included in the second cell unit are the structure shown in the first possibility. To be specific,
the first subcell includes the transparent substrate, the transparent conducting layer, the functional layers, and the first back electrode, and the functional layers include the N-type layer, the light-harvesting layer, and the P-type layer. The transparent substrate, the transparent conducting layer, the functional layers, and the first back electrode are arranged in a bottom-to-top sequence, the N-type layer, the light-harvesting layer, and the P-type layer are arranged in a first sequence, and the first sequence includes a bottom-to-top sequence or a top-to-bottom sequence.

The second subcell includes the transparent substrate, the transparent conducting layer, the functional layers, and the second back electrode, and the functional layers include the N-type layer, the light-harvesting layer, and the P-type layer. The transparent substrate, the transparent conducting layer, the functional layers, and the second back electrode are arranged in a bottom-to-top sequence, the N-type layer, the light-harvesting layer, and the P-type layer are arranged in a second sequence, the second sequence includes a bottom-to-top sequence or a top-to-bottom sequence, and the first sequence is opposite to the second sequence.

The structure of the third subcell is the same as that of the first subcell.

The structure of the fourth subcell is the same as that of the second subcell.

The transparent substrates of the first to fourth subcells are an integral structure, the transparent conducting layers of the first subcell and the second subcell are an integral structure, and the transparent conducting layers of the third subcell and the fourth subcell are an integral structure.

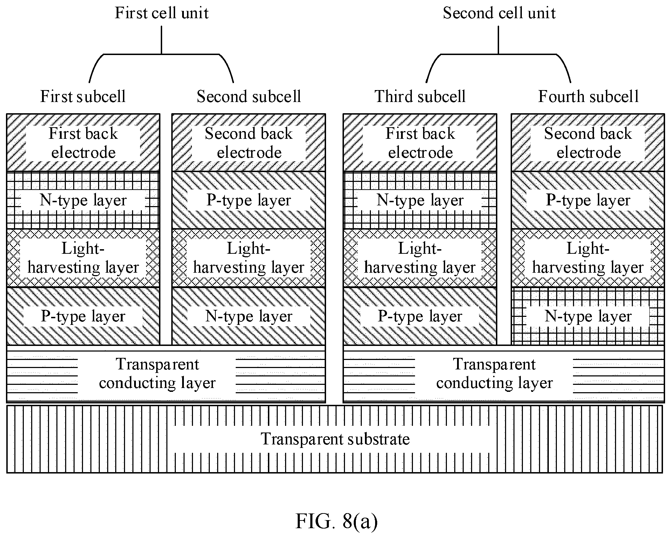

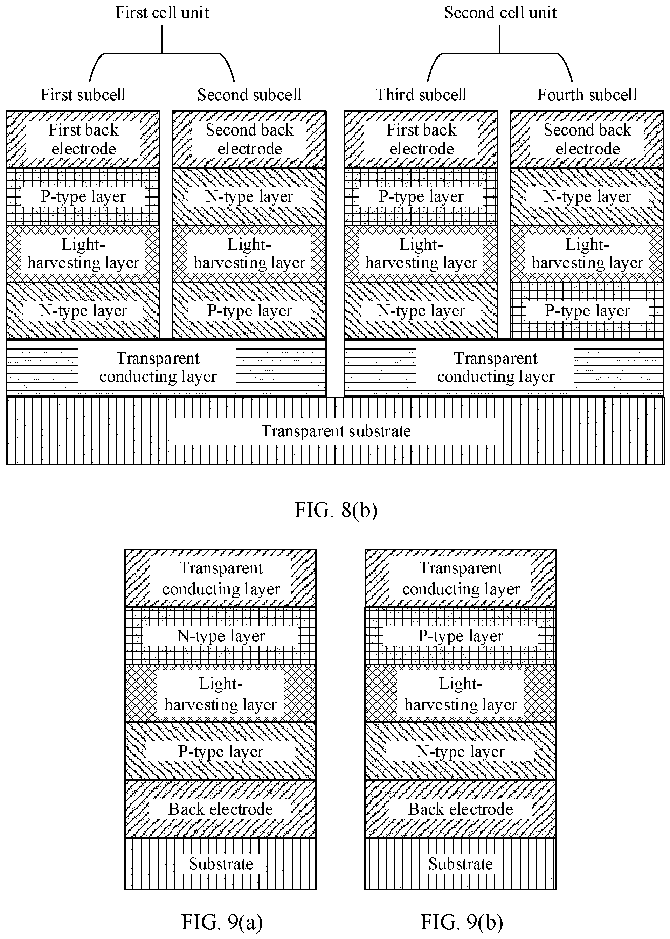

For ease of understanding, a structural form of the first cell unit and the second cell unit in the first possibility is described with reference to FIG. 8(a) and FIG. 8(b). FIG. 8(a) and FIG. 8(b) show a structural form of two cell units according to an embodiment of this application.

It can be seen from FIG. 8(a) and FIG. 8(b) that, the first sequence shown in FIG. 8(a) is the top-to-bottom sequence, and the second sequence is the bottom-to-top sequence; the first sequence shown in FIG. 8(b) is the bottom-to-top sequence, and the second sequence is the top-to-bottom sequence.

In a second possibility, the subcell includes a substrate, a back electrode, functional layers, and a transparent conducting layer, and the functional layers include an N-type layer, a light-harvesting layer, and a P-type layer.

The substrate, the back electrode, the functional layers, and the transparent conducting layer are arranged in a bottom-to-top sequence, and the N-type layer, the light-harvesting layer, and the P-type layer are arranged in a bottom-to-top sequence or in a top-to-bottom sequence.

For ease of understanding, a structural form of the subcell in the second possibility is described with reference to FIG. 9(a) and FIG. 9(b). FIG. 9(a) and FIG. 9(b) are schematic diagrams of a structure of another subcell according to an embodiment of this application.

It can be seen from FIG. 9(a) and FIG. 9(b) that, the N-type layer, the light-harvesting layer, and the P-type layer shown in FIG. 9(a) are arranged in a top-to-bottom sequence, and the N-type layer, the light-harvesting layer, and the P-type layer shown in FIG. 9(b) are arranged in a bottom-to-top sequence.

For example, the structure of the first subcell and the second subcell that are included in the first cell unit and the structure of the third subcell and the fourth subcell that are included in the second cell unit are the structure shown in the second possibility. To be specific,
the first subcell includes the substrate, the first back electrode, the functional layers, and the transparent conducting layer, and the functional layers include the N-type layer, the light-harvesting layer, and the P-type layer. The substrate, the first back electrode, the functional layers, and the transparent conducting layer are arranged in a bottom-to-top sequence, the N-type layer, the light-harvesting layer, and the P-type layer are arranged in a first sequence, and the first sequence includes a bottom-to-top sequence or a top-to-bottom sequence.

The second subcell includes the substrate, the second back electrode, the functional layers, and the transparent conducting layer, and the functional layers include the N-type layer, the light-harvesting layer, and the P-type layer. The substrate, the second back electrode, the functional layers, and the transparent conducting layer are arranged in a bottom-to-top sequence, the N-type layer, the light-harvesting layer, and the P-type layer are arranged in a second sequence, the second sequence includes a bottom-to-top sequence or a top-to-bottom sequence, and the first sequence is opposite to the second sequence.

The structure of the third subcell is the same as that of the first subcell.

The structure of the fourth subcell is the same as that of the second subcell.

The substrates of the first to fourth subcells are an integral structure, the transparent conducting layers of the first subcell and the second subcell are an integral structure, and the transparent conducting layers of the third subcell and the fourth subcell are an integral structure.

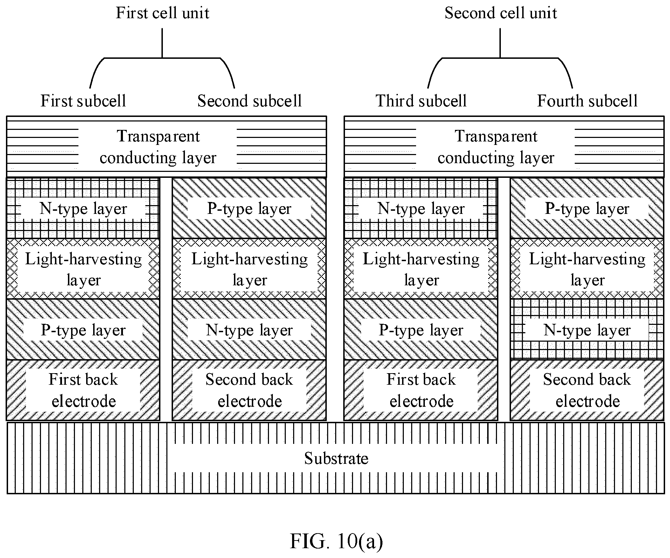

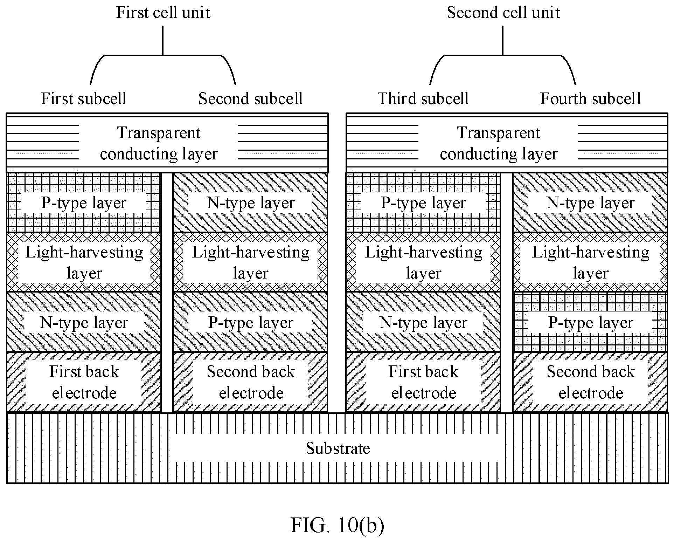

For ease of understanding, a structural form of the first cell unit and the second cell unit in the second possibility is described with reference to FIG. 10(a) and FIG. 10(b). FIG. 10(a) and FIG. 10(b) show another structural form of two cell units according to an embodiment of this application.

It can be seen from FIG. 10(a) and FIG. 10(b) that, the first sequence shown in FIG. 10(a) is the top-to-bottom sequence, and the second sequence is the bottom-to-top sequence; the first sequence shown in FIG. 10(b) is the bottom-to-top sequence, and the second sequence is the top-to-bottom sequence.

It should be noted that the subcell in the second possibility may use an opaque substrate material, and selection of substrate materials is wider, to further reduce costs of the assembly and add use scenarios.

In addition, in the cell assembly of the type of series-parallel hybrid connection provided in this embodiment of this application, the cell unit includes P-I-N type and N-I-P type subcells that share a transparent conducting layer and that are connected in series, and between different cell groups, corresponding positive back electrodes are connected in parallel, and corresponding negative back electrodes are connected in parallel between cell units in the different cell groups, to avoid contact resistance loss generated by direct contact between a metal back electrode and a bottom electrode through P2 cutting in a conventional assembly, avoid leakage loss brought by direct contact between the metal back electrode and functional layers, and the like, thereby optimizing electrical loss of the conventional assembly.

Optionally, when the light-harvesting layer is made from single-crystal perovskite, adjacent subcells each include two light-harvesting layers, and a slot is provided between the light-harvesting layers.

For example, a first slot is provided between the first subcell and the second subcell, and the first slot is located between the first back electrode of the first subcell and the second back electrode of the second subcell, between the N-type layer of the first subcell and the P-type layer of the second subcell, between the P-type layer of the first subcell and the N-type layer of the second subcell, and between the light-harvesting layer of the first subcell and the light-harvesting layer of the second subcell.

Optionally, when the light-harvesting layer is made from single-crystal perovskite, a second slot is provided between the two adjacent cell units, and the second slot is located between the first back electrode of the third subcell and the second back electrode of the second subcell, between the N-type layer of the third subcell and the P-type layer of the second subcell, between the P-type layer of the third subcell and the N-type layer of the second subcell, between the light-harvesting layer of the third subcell and the light-harvesting layer of the second subcell, and between a first bottom electrode and a second bottom electrode.

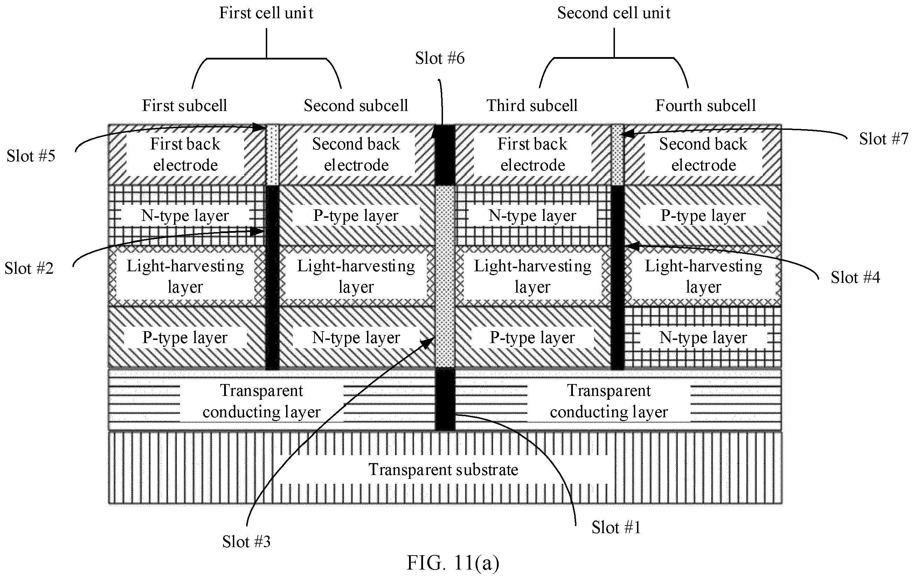

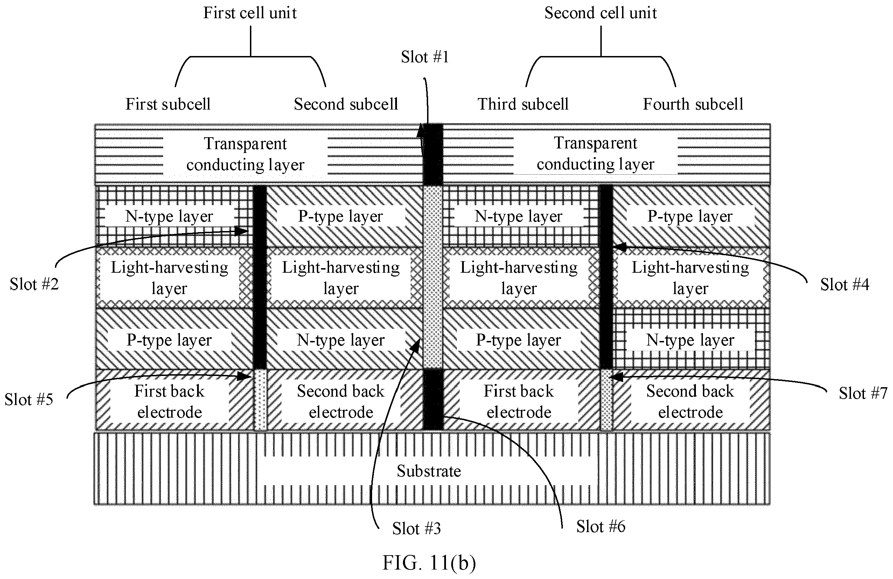

The third subcell (for example, the third subcell shown in FIG. 11(a) and FIG. 11(b)) and the second subcell (for example, the second subcell shown in FIG. 11(a) and FIG. 11(b)) are cell units that are adjacent in two subcells separately included in the two adjacent cell units, and the first bottom electrode and the second bottom electrode (for example, two transparent conducting layers shown in FIG. 11(a) and FIG. 11(b)) are bottom electrodes separately included in the two adjacent cell units.

That a second slot is provided between the two adjacent cell units may be understood as follows: A slot is provided between functional layers of two subcells by using a spacing slot (for example, a slot #1 shown in FIG. 11(a) and FIG. 11(b)) between transparent conducting layers of the two cell units as a reference, and/or a slot is provided between back electrodes of the two subcells.

For ease of understanding, slots that may be provided between two subcells and slots that may be provided between two cell units are described with reference to FIG. 11(a) and FIG. 11(b).

FIG. 11(a) and FIG. 11(b) are schematic diagrams of a slotting manner according to an embodiment of this application. It can be seen from FIG. 11(a) and FIG. 11(b) that, the subcell structure shown in FIG. 11(a) is the structure shown in the first possibility, and the subcell structure shown in FIG. 11(b) is the structure shown in the second possibility.

It should be understood that, FIG. 11(a) and FIG. 11(b) show only a case in which sorting of the functional layers is one of the first possibility and the second possibility (the first sequence is the top-to-bottom sequence, and the second sequence is the bottom-to-top sequence), and a case in which sorting of the functional layers is the other one (the first sequence is the bottom-to-top sequence, and the second sequence is the top-to-bottom sequence) is similar to this sorting case. Details are not described.

For example, a slot #2 is provided between the functional layers of the first subcell and the functional layers of the second subcell, for example, the slot #2 shown in FIG. 11(a) and FIG. 11(b).

For example, a slot #4 is provided between the functional layers of the third subcell and the functional layers of the fourth subcell, for example, the slot #4 shown in FIG. 11(a) and FIG. 11(b).

For example, a slot #5 is provided between the first back electrode of the first subcell and the second back electrode of the second subcell, for example, the slot #5 shown in FIG. 11(a) and FIG. 11(b).

For example, a slot #7 is provided between the first back electrode of the third subcell and the second back electrode of the fourth subcell, for example, the slot #7 shown in FIG. 11(a) and FIG. 11(b).

For example, a slot #3 is provided between the functional layers of the second subcell and the functional layers of the third subcell, where a position of the slot #3 corresponds to that of the slot #1, for example, the slot #3 shown in FIG. 11(a) and FIG. 11(b).

For example, a slot #6 is provided between the second back electrode of the second subcell and the first back electrode of the third subcell, where a position of the slot #6 corresponds to that of the slot #1, for example, the slot #6 shown in FIG. 11(a) and FIG. 11(b).

Optionally, at least one of the slot #1, the slot #2, the slot #3, the slot #4, the slot #5, the slot #6, and the slot #7 is filled with an insulating material.

The slot #2 and the slot #5 may be collectively referred to as the first slot provided between the first subcell and the second subcell, the slot #4 and the slot #7 may be collectively referred to as the first slot provided between the third subcell and the fourth subcell, and the slot #1, the slot #3, and the slot #6 may be collectively referred to as the second slot provided between the first cell unit and the second cell unit.

Optionally, when the light-harvesting layer is made from polycrystalline perovskite, and when the light-harvesting layer uses polycrystalline perovskite, an organic light-harvesting material, or the like, considering that a diffusion length of a carrier of the light-harvesting layer is relatively small, the light-harvesting layer may not be slotted, and the light-harvesting layers of adjacent subcells are an integral structure.

For example, the first slot is provided between the first subcell and the second subcell, and the first slot is located between the first back electrode of the first subcell and the second back electrode of the second subcell, between the N-type layer of the first subcell and the P-type layer of the second subcell, and between the P-type layer of the first subcell and the N-type layer of the second subcell.

Optionally, when the light-harvesting layer is made from polycrystalline perovskite, the second slot is provided between the two adjacent cell units, and the second slot is located between the first back electrode of the third subcell and the second back electrode of the second subcell, between the N-type layer of the third subcell and the P-type layer of the second subcell, between the P-type layer of the third subcell and the N-type layer of the second subcell, and between the first bottom electrode and the second bottom electrode.

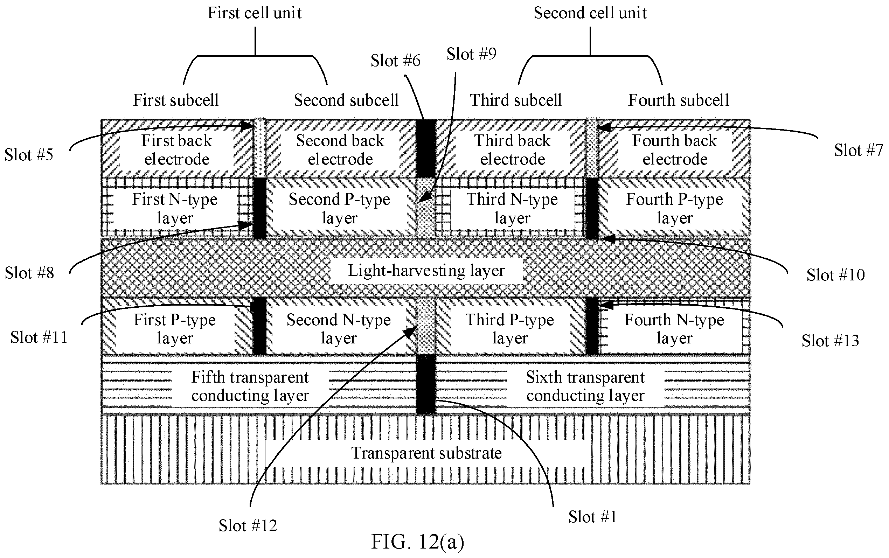

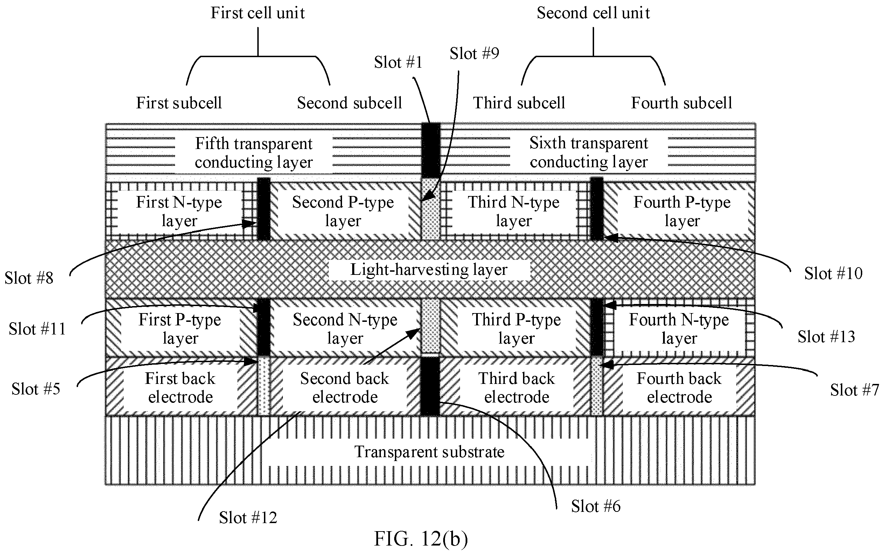

The third subcell (for example, the third subcell shown in FIG. 12(a) and FIG. 12(b)) and the second subcell (for example, the second subcell shown in FIG. 12(a) and FIG. 12(b)) are cell units that are adjacent in two subcells separately included in the two adjacent cell units, and the first bottom electrode and the second bottom electrode (for example, two transparent conducting layers shown in FIG. 12(a) and FIG. 12(b)) are bottom electrodes separately included in the two adjacent cell units.

That a second slot is provided between the two adjacent cell units may be understood as follows: A slot is provided between the N-type layer and the P-type layer in the functional layers of two subcells by using a spacing slot (for example, a slot #1 shown in FIG. 12(a) and FIG. 12(b)) between transparent conducting layers of the two cell units as a reference, and/or a slot is provided between back electrodes of the two subcells.

For ease of understanding, slots that may be provided between two subcells and slots that may be provided between two cell units are described with reference to FIG. 12(a) and FIG. 12(b).

FIG. 12(a) and FIG. 12(b) are schematic diagrams of another slotting manner according to an embodiment of this application. It can be seen from FIG. 12(a) and FIG. 12(b) that, the subcell structure shown in FIG. 12(a) is the structure shown in the first possibility, and the subcell structure shown in FIG. 12(b) is the structure shown in the second possibility.

It should be understood that, FIG. 12(a) and FIG. 12(b) show only a case in which sorting of the functional layers is one of the first possibility and the second possibility (the first sequence is the top-to-bottom sequence, and the second sequence is the bottom-to-top sequence), and a case in which sorting of the functional layers is the other one (the first sequence is the bottom-to-top sequence, and the second sequence is the top-to-bottom sequence) is similar to this sorting case. Details are not described.

For example, a slot #8 is provided between the N-type layer of the first subcell and the P-type layer of the second subcell, for example, the slot #8 shown in FIG. 12(a) and FIG. 12(b).

For example, a slot #11 is provided between the P-type layer of the first subcell and the N-type layer of the second subcell, for example, the slot #11 shown in FIG. 12(a) and FIG. 12(b).

For example, a slot #10 is provided between the N-type layer of the third subcell and the P-type layer of the fourth subcell, for example, the slot #10 shown in FIG. 12(a) and FIG. 12(b).

For example, a slot #13 is provided between the P-type layer of the third subcell and the N-type layer of the fourth subcell, for example, the slot #13 shown in FIG. 12(a) and FIG. 12(b).

For example, a slot #5 is provided between the first back electrode of the first subcell and the second back electrode of the second subcell, for example, the slot #5 shown in FIG. 12(a) and FIG. 12(b).

For example, a slot #7 is provided between the first back electrode of the third subcell and the second back electrode of the fourth subcell, for example, the slot #7 shown in FIG. 12(a) and FIG. 12(b).

For example, a slot #12 is provided between the N-type layer of the second subcell and the P-type layer of the third subcell, where a position of the slot #12 corresponds to that of the slot #1, for example, the slot #12 shown in FIG. 12(a) and FIG. 12(b).

For example, a slot #9 is provided between the P-type layer of the second subcell and the N-type layer of the third subcell, where a position of the slot #9 corresponds to that of the slot #1, for example, the slot #9 shown in FIG. 12(a) and FIG. 12(b).

For example, a slot #6 is provided between the second back electrode of the second subcell and the first back electrode of the third subcell, where a position of the slot #6 corresponds to that of the slot #1, for example, the slot #6 shown in FIG. 12(a) and FIG. 12(b).

Optionally, at least one of the slot #1, the slot #5, the slot #6, the slot #7, the slot #8, the slot #9, the slot #10, the slot #11, the slot #12, and the slot #13 is filled with an insulating material.

The slot #5, the slot #8, and the slot #11 may be collectively referred to as the first slot provided between the first subcell and the second subcell, the slot #10, the slot #13 and the slot #7 may be collectively referred to as the first slot provided between the third subcell and the fourth subcell, and the slot #1, the slot #6, the slot #9, and the slot #12 may be collectively referred to as the second slot provided between the first cell unit and the second cell unit.

For example, the insulating material in this embodiment of this application includes but is not limited to one or more of insulating materials such as aluminum oxide Al₂O₃, silicon dioxide SiO₂, a ceramic material, polystyrene, polypropylene, epoxy plastic, polyester, polycarbonate, polytetrafluoroethylene, and polyimide.

For example, the transparent conducting layer (for example, the first transparent conducting layer to the fourth transparent conducting layer shown above) in this embodiment of this application may be made from at least one of the following materials:
a transparent conductive oxide TCO, a conductive polymer, a metal nanowire, a metal mesh, graphene, a carbon nanotube, metal or an alloy, a metal oxide, and the like.

For example, the N-type layer (for example, the first N-type layer to the fourth N-type layer shown above) in this embodiment of this application may be made from at least one of the following materials:

N-type oxides such as titanium dioxide TiO₂, tin dioxide SnO₂, and zinc oxide ZnO, or N-type organics such as fullerenes, fullerene derivatives (such as PCBM), and polystyrenesulfonate (such as PSSA), and metal phthalocyanine molecular materials (such as copper phthalocyanine CuPc) and other compounds and derivatives thereof.

For example, the P-type layer (for example, the first P-type layer to the fourth P-type layer shown above) in this embodiment of this application may be made from at least one of the following materials:
nickel oxide (NiOx), molybdenum oxide (MoOx), tungsten oxide (WOx), vanadium pentoxide (V2O5), cuprous thicyanate (CuSCN), poly(3,4-ethylenedioxythiophene)-polystyrenesulfonate (such as PEDOT:PSS), poly(3-hexylthiophene-2,5-diyl)(P3HT), 3,4-ethylenedioxythiophene (EDOT), 4-butyl-N,N-diphenylaniline homopolymer (Poly-TPD), poly[bis(4-phenyl)(2,4,6-trimethylphenyl)amine] (PTAA), 2,2',7,7'-tetra[N,N-di(4-methoxyphenyl)amino]-9,9'-spirobifluorene (Spiro-OMe-TAD), and the like.

For example, the light-harvesting layer (for example, the first light-harvesting layer to the fourth light-harvesting layer shown above) in this embodiment of this application may be made from perovskite and/or an organic material.

For example, the back electrode (for example, the first back electrode and the second back electrode shown above) in this embodiment of this application may be made from at least one of the following materials:
metal or an alloy such as aluminum (Al), gold (Au), silver (Ag), copper (Cu), or titanium (Ti), a transparent conductive oxide TCO, a conductive polymer, a metal nanowire, a metal mesh, a carbon material, and the like.

For example, the transparent substrate (for example, the first transparent substrate to the fourth transparent substrate shown above) in this embodiment of this application may be a flexible substrate, for example, is made from at least one of the following materials:
polyethylene terephthalate (PET), polyethylene naphthalate (PEN), polyimide (PI), polydimethyl siloxane (PDMS), and the like.

In another possible implementation, the transparent substrate (for example, the first transparent substrate to the fourth transparent substrate shown above) in this embodiment of this application may be a rigid substrate, for example, glass.

For example, the substrate (for example, the first substrate to the fourth substrate shown above) in this embodiment of this application may be made from at least one of the following materials:
flexible or rigid substrates such as glass, stainless steel or other metal, fiber fabric, polyimide (PI), polyethylene terephthalate (PET), polybutylene terephthalate (PBT), polyethylene naphthalate (PEN), polydimethylsiloxane (PDMS) and derivatives thereof, and the materials have characteristics of transparency or opacity.

For ease of understanding this application, the following describes the structure of the foregoing cell assembly by using examples in which K=1, M=2, and N=2, and K=1, M=3, and N=1.

When K=1, M=2, and N=2:

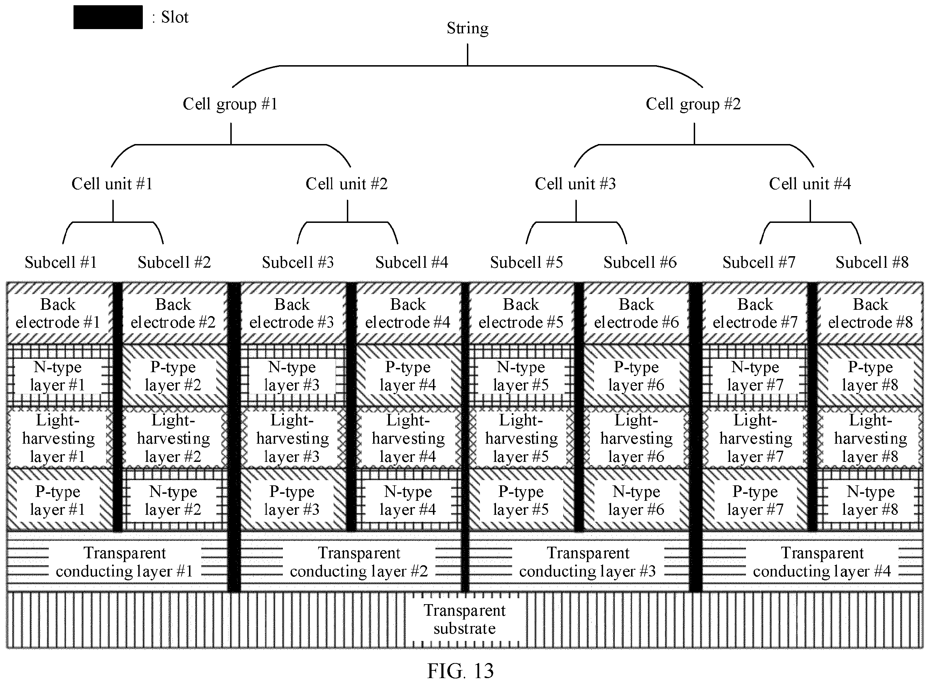

FIG. 13 is a schematic diagram of a cross-sectional view of a cell assembly according to an embodiment of this application.

It can be seen from FIG. 13 that, the cell assembly includes one cell string.

The cell string includes two cell groups, for example, a cell group #1 and a cell group #2 shown in FIG. 13.

Each cell group includes two cell units. The cell group #1 includes a cell unit #1 and a cell unit #2, and the cell group #2 includes a cell unit #3 and a cell unit #4.

Each cell unit includes two subcells. The cell unit #1 includes a subcell #1 and a subcell #2, the subcell #1 is a P-I-N type subcell, and the subcell #2 is an N-I-P type subcell; the cell unit #2 includes a subcell #3 and a subcell #4, the subcell #3 is a P-I-N type subcell and the subcell #4 is an N-I-P type subcell.

The cell unit #3 includes a subcell #5 and a subcell #6, the subcell #5 is a P-I-N type subcell, and the subcell #6 is an N-I-P type subcell; the cell unit #4 includes a subcell #7 and a subcell #8, the subcell #7 is a P-I-N type subcell and the subcell #8 is an N-I-P type subcell.

Specifically, the subcell #1 includes a back electrode #1, an N-type layer #1, a light-harvesting layer #1, a P-type layer #1, a transparent conducting layer #1, and a transparent substrate in sequence from top to bottom.

The subcell #2 includes a back electrode #2, a P-type layer #2, a light-harvesting layer #2, an N-type layer #2, the transparent conducting layer #1, and the transparent substrate in sequence from top to bottom.

The subcell #3 includes a back electrode #3, an N-type layer #3, a light-harvesting layer #3, a P-type layer #3, a transparent conducting layer #2, and the transparent substrate in sequence from top to bottom.

The subcell #4 includes a back electrode #4, a P-type layer #4, a light-harvesting layer #4, an N-type layer #4, the transparent conducting layer #2, and the transparent substrate in sequence from top to bottom.

The subcell #5 includes a back electrode #5, an N-type layer #5, a light-harvesting layer #5, a P-type layer #5, a transparent conducting layer #3, and the transparent substrate in sequence from top to bottom.

The subcell #6 includes a back electrode #6, a P-type layer #6, a light-harvesting layer #6, an N-type layer #6, the transparent conducting layer #3, and the transparent substrate in sequence from top to bottom.

The subcell #7 includes a back electrode #7, an N-type layer #7, a light-harvesting layer #7, a P-type layer #7, a transparent conducting layer #4, and the transparent substrate in sequence from top to bottom.

The subcell #8 includes a back electrode #8, a P-type layer #8, a light-harvesting layer #8, an N-type layer #8, the transparent conducting layer #4, and the transparent substrate in sequence from top to bottom.

It can be seen from FIG. 13 that, the transparent conducting layer of the subcell #1 and the transparent conducting layer of the subcell #2 are an integral structure, the transparent conducting layer of the subcell #3 and the transparent conducting layer of the subcell #4 are an integral structure, the transparent conducting layer of the subcell #5 and the transparent conducting layer of the subcell #6 are an integral structure, and the transparent conducting layer of the subcell #7 and the transparent conducting layer of the subcell #8 are an integral structure; and the transparent substrates of the subcell #1, the subcell #2, the subcell #3, the subcell #4, the subcell #5, the subcell #6, the subcell #7, and the subcell #8 are an integral structure.

Further, it can be seen from FIG. 13 that, a slot is provided between the transparent conducting layer #1 and the transparent conducting layer #2, or in other words, a slot is provided between the cell unit #1 and the cell unit #2; a slot is provided between the transparent conducting layer #2 and the transparent conducting layer #3, or in other words, a slot is provided between the cell unit #2 and the cell unit #3; and a slot is provided between the transparent conducting layer #3 and the transparent conducting layer #4, or in other words, a slot is provided between the cell unit #3 and the cell unit #4.

Further, it can also be seen from FIG. 13 that, a slot is provided between functional layers of two subcells, and a slot is provided between back electrodes of two subcells.

It should be understood that, FIG. 13 is merely an example for describing a case in which K=1, M=2, and N=2. A possible structural form of the cell assembly in this application does not constitute any limitation on the protection scope of this application, and may alternatively be another structural from.

For example, the subcell #1 is an N-I-P type subcell, and the subcell #2 is a P-I-N type subcell.

In another example, a slot is provided between the N-type layer and the P-type layer in the functional layers of two subcells, and no slot is provided between the light-harvesting layers.

In another example, an insulating material is filled in the provided slot.

In another example, the structure of the subcell may include the transparent conducting layer, the functional layers, the back electrode, and the substrate in sequence from top to bottom.

Possible structural forms of the cell assembly in the case in which K=1, M=2, and N=2 are not described herein one by one by using examples.

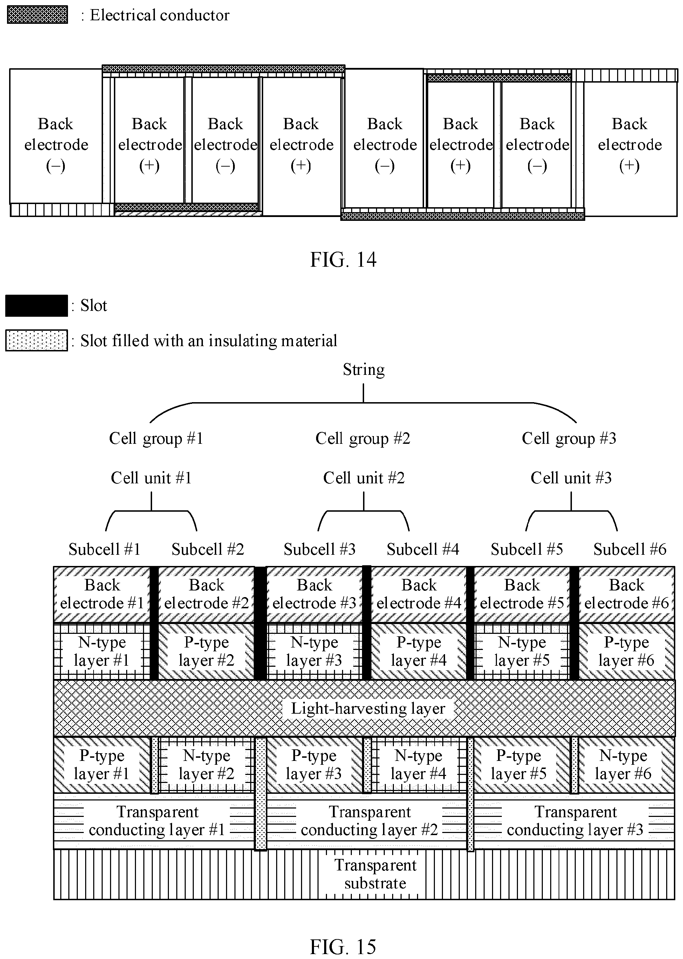

FIG. 14 is a schematic diagram of a top view of a cell assembly according to an embodiment of this application. The top view and the cross-sectional view shown in FIG. 13 correspond to a cell assembly with a same structure.

It can be seen from FIG. 14 that, back electrodes of each cell unit include a positive back electrode and a negative back electrode (for example, the back electrode (+) and the back electrode (-) shown in FIG. 14).

The second back electrode (the back electrode (+)) is connected to the third back electrode (the back electrode (-)) by using a first electrical conductor, to identify that the cell unit #1 is connected in series to the cell unit #2; the sixth back electrode (the back electrode (+)) is connected to the seventh back electrode (the back electrode (-)) by using the first electrical conductor, to identify that the cell unit #3 is connected in series to the cell unit #4.

The first back electrode (the back electrode (-)) is connected to the fifth back electrode (the back electrode (-)) by using a second electrical conductor, and the fourth back electrode (the back electrode (+)) is connected to the eighth back electrode (the back electrode (+)) by using the second electrical conductor, to identify that the cell group # 1 is connected in parallel to the cell group #2. The first back electrode and the fourth back electrode may both be referred to as back electrodes on an outermost side of the cell group #1, and the fifth back electrode and the eighth back electrode may both be referred to as back electrodes on an outermost side of the cell group #2.

When K=1, M=3, and N=1:

FIG. 15 is a schematic diagram of a cross-sectional view of another cell assembly according to an embodiment of this application.

It can be seen from FIG. 15 that, the cell assembly includes one cell string.

The cell string includes three cell groups, for example, a cell group #1, a cell group #2, and a cell group #1 shown in FIG. 15.

Each cell group includes one cell unit. The cell group #1 includes a cell unit #1, the cell group #2 includes a cell unit #2, and the cell group#3 includes a cell unit #3.

Each cell unit includes two subcells. The cell unit #1 includes a subcell #1 and a subcell #2, the subcell #1 is a P-I-N type subcell, and the subcell #2 is an N-I-P type subcell. The cell unit #2 includes a subcell #3 and a subcell #4, the subcell #3 is a P-I-N type subcell, and the subcell #4 is an N-I-P type subcell. The cell unit # 3 includes a subcell #5 and a subcell #6, the subcell #5 is a P-I-N type subcell, and the subcell #6 is an N-I-P type subcell.

Specifically, the subcell #1 includes a back electrode #1, an N-type layer #1, the light-harvesting layer, a P-type layer #1, a transparent conducting layer #1, and a transparent substrate in sequence from top to bottom.

The subcell #2 includes a back electrode #2, a P-type layer #2, the light-harvesting layer, an N-type layer #2, the transparent conducting layer #1, and the transparent substrate in sequence from top to bottom.

The subcell #3 includes a back electrode #3, an N-type layer #3, the light-harvesting layer, a P-type layer #3, a transparent conducting layer #2, and the transparent substrate in sequence from top to bottom.

The subcell #4 includes a back electrode #4, a P-type layer #4, the light-harvesting layer, an N-type layer #4, the transparent conducting layer #2, and the transparent substrate in sequence from top to bottom.

The subcell #5 includes a back electrode #5, an N-type layer #5, the light-harvesting layer, a P-type layer #5, a transparent conducting layer #3, and the transparent substrate in sequence from top to bottom.

The subcell #6 includes a back electrode #6, a P-type layer #6, the light-harvesting layer, an N-type layer #6, the transparent conducting layer #3, and the transparent substrate in sequence from top to bottom.

It can be learned from FIG. 15 that, the transparent conducting layer of the subcell #1 and the transparent conducting layer of the subcell #2 are an integral structure; the transparent conducting layer of the subcell #3 and the transparent conducting layer of the subcell #4 are an integral structure (or share one transparent conducting layer); the transparent conducting layer of the subcell #5 and the transparent conducting layer of the subcell #6 are an integral structure; the transparent substrates of subcell #1, subcell #2, subcell #3, subcell #4, subcell #5, and subcell #6 are an integral structure (or share one transparent substrate); and the light-harvesting layers of the subcell #1, the subcell #2, the subcell #3, the subcell #4, the subcell #5, and the subcell #6 are an integral structure (or share one light-harvesting layer).

Further, it can be seen from FIG. 15 that, a slot is provided between the transparent conducting layer #1 and the transparent conducting layer #2, or in other words, a slot is provided between the cell unit #1 and the cell unit #2; and a slot is provided between the transparent conducting layer #2 and the transparent conducting layer #3, or in other words, a slot is provided between the cell unit #2 and the cell unit #3.

Further, it can be further learned from FIG. 15 that, a slot is provided between the N-type layer and the P-type layer of functional layers of two subcells, and no slot is provided between the light-harvesting layer; and a slot is provided between back electrodes of two subcells.

For example, an insulating material is filled in a slot between the N-type layer and the P-type layer (for example, an insulating material is filled in a slot between the P-type layer #1 and the N-type layer #2, a slot between the N-type layer #2 and the P-type layer #3, a slot between the P-type layer #3 and the N-type layer #4, a slot between the N-type layer #4 and the P-type layers #5, and a slot between the P-type layer #5 and the N-type layer #6 shown in FIG. 15).

For example, an insulating material is filled in the slot provided between the transparent conducting layers (for example, an insulating material is filled in the slot between the transparent conducting layer #1 and the transparent conducting layer #2, and the slot between the transparent conducting layer #2 and the transparent conducting layer #3 shown in FIG. 15).

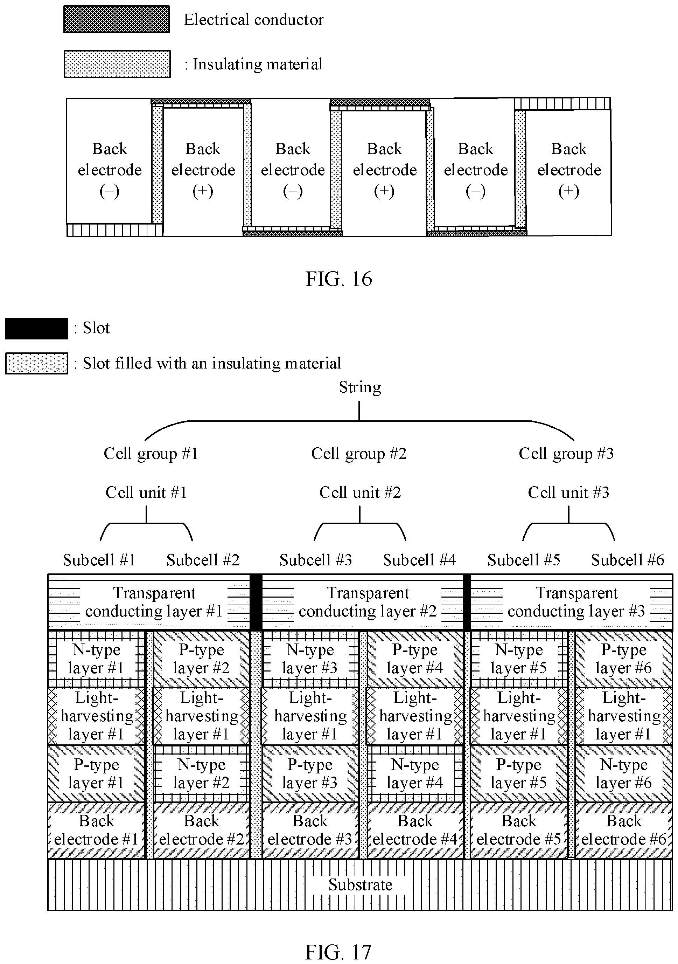

FIG. 16 is a schematic diagram of a top view of another cell assembly according to an embodiment of this application. The top view and the cross-sectional view shown in FIG. 15 correspond to a cell assembly with a same structure.

It can be seen from FIG. 16 that, back electrodes of each cell unit include a positive back electrode and a negative back electrode (for example, the back electrode (+) and the back electrode (-) shown in FIG. 16).

Because each cell group in the cell assembly shown in FIG. 15 includes only one cell unit, and the cell groups are connected in parallel, the cell units are also connected in parallel.

The first back electrode (the back electrode (-)) is connected to the third back electrode (the back electrode (-)) by using a second electrical conductor, the third back electrode (the back electrode (-)) is connected to the fifth back electrode (the back electrode (-)) by using the second electrical conductor, the second back electrode (the back electrode (+)) is connected to the fourth back electrode (the back electrode (+)) by using the second electrical conductor, and the fourth back electrode (back electrode (+)) is connected to the sixth back electrode (back electrode (+)) by using the second electrical conductor, to identify that the cell group #1, the cell group #2, and the cell group #3 are connected in parallel. The first back electrode and the second back electrode may both be referred to as back electrodes on an outermost side of the cell group #1. The third back electrode and the fourth back electrode may both be referred to as back electrodes on an outermost side of the cell group #2. The fifth back electrode and the sixth back electrode may both be referred to as back electrodes on an outermost side of the cell group #3.

FIG. 17 is a schematic diagram of a cross-sectional view of still another cell assembly according to an embodiment of this application;

It can be seen from FIG. 17 that, the cell assembly includes one cell string.

The cell string includes three cell groups, for example, a cell group #1, a cell group #2, and a cell group #3 shown in FIG. 17.

Each cell group includes one cell unit. The cell group #1 includes a cell unit #1, the cell group #2 includes a cell unit #2, and the cell group#3 includes a cell unit #3.

Each cell unit includes two subcells. The cell unit #1 includes a subcell #1 and a subcell #2, the subcell #1 is a P-I-N type subcell, and the subcell #2 is an N-I-P type subcell. The cell unit #2 includes a subcell #3 and a subcell #4, the subcell #3 is a P-I-N type subcell, and the subcell #4 is an N-I-P type subcell. The cell unit # 3 includes a subcell #5 and a subcell #6, the subcell #5 is a P-I-N type subcell, and the subcell #6 is an N-I-P type subcell.

Specifically, the subcell #1 includes a transparent conducting layer #1, an N-type layer #1, a light-harvesting layer #1, a P-type layer #1, a back electrode #1, and a substrate in sequence from top to bottom.

The subcell #2 includes the transparent conducting layer #1, a P-type layer #2, a light-harvesting layer #2, an N-type layer #2, a back electrode #2, and the substrate in sequence from top to bottom.

The subcell #3 includes a transparent conducting layer #2, an N-type layer #3, a light-harvesting layer #3, a P-type layer #3, a back electrode #3, and the substrate in sequence from top to bottom.

The subcell #4 includes the transparent conducting layer #2, a P-type layer #4, a light-harvesting layer #4, an N-type layer #4, a back electrode #4, and the substrate in sequence from top to bottom.

The subcell #5 includes a transparent conducting layer #3, an N-type layer #5, a light-harvesting layer #5, a P-type layer #5, a back electrode #5, and the substrate in sequence from top to bottom.

The subcell #6 includes the transparent conducting layer #3, a P-type layer #6, a light-harvesting layer #6, an N-type layer #6, a back electrode #6, and the substrate in sequence from top to bottom.

It can be seen from FIG. 17 that, the transparent conducting layer of the subcell #1 and the transparent conducting layer of the subcell #2 are an integral structure, the transparent conducting layer of the subcell #3 and the transparent conducting layer of the subcell #4 are an integral structure, and the transparent conducting layer of the subcell #5 and the transparent conducting layer of the subcell #6 are an integral structure; and the substrates of the subcell #1, the subcell #2, the subcell #3, the subcell #4, the subcell #5, and the subcell #6 are an integral structure.

Further, it can be seen from FIG. 17 that, a slot is provided between the transparent conducting layer #1 and the transparent conducting layer #2, or in other words, a slot is provided between the cell unit #1 and the cell unit #2; and a slot is provided between the transparent conducting layer #2 and the transparent conducting layer #3, or in other words, a slot is provided between the cell unit #2 and the cell unit #3.

Further, it can also be seen from FIG. 17 that, a slot is provided between functional layers of two subcells, and a slot is provided between back electrodes of two subcells.

For example, an insulating material may be further filled in a slot between functional layers and/or a slot between back electrodes (for example, an insulating material is filled in a slot between the back electrode #1 and the back electrode #2, a slot between the back electrode #2 and the back electrode #3, a slot between the back electrode #3 and the back electrode #4, a slot between the back electrode #4 and the back electrode #5, a slot between the back electrode #5 and the back electrode #6 shown in FIG. 17; and an insulating material is filled in a slot between a functional layer #1 and a functional layer #2, a slot between the functional layer #2 and a functional layer #3, a slot between the functional layer #3 and a functional layer #4, a slot between the functional layer #4 and a functional layer #5, and a slot between the functional layer #5 and a functional layer #6 shown in FIG. 17).

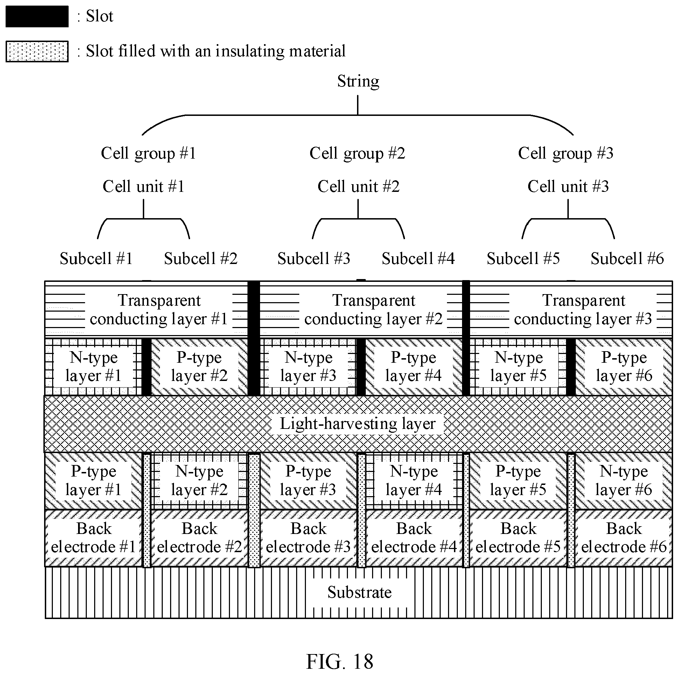

For example, the light-harvesting layers of the subcell #1, the subcell #2, the subcell #3, the subcell #4, the subcell #5, and the subcell #6 in FIG. 17 may be an integral structure, as shown in FIG. 18. FIG. 18 is a schematic diagram of a cross-sectional view of still another cell assembly according to an embodiment of this application.

It can be further learned from FIG. 18 that, a slot is provided between an N-type layer and a P-type layer of functional layers of two subcells, and no slot is provided between the light-harvesting layer; and a slot is provided between back electrodes of two subcells.

For example, an insulating material is filled in a slot between the N-type layer and the P-type layer (for example, an insulating material is filled in a slot between a P-type layer #1 and an N-type layer #2, a slot between the N-type layer #2 and a P-type layer #3, a slot between the P-type layer #3 and an N-type layer #4, a slot between the N-type layer #4 and a P-type layers #5, and a slot between the P-type layer #5 and an N-type layer #6 shown in FIG. 18).

For example, an insulating material may be further filled in the slot between the back electrodes (for example, an insulating material is filled in a slot between a back electrode #1 and a back electrode #2, a slot between the back electrode #2 and a back electrode #3, a slot between the back electrode #3 and a back electrode #4, a slot between the back electrode #4 and a back electrode #5, and a slot between the back electrode #5 and a back electrode #6 shown in FIG. 18).

It should be understood that, FIG. 15 to FIG. 18 are merely examples for describing a case in which K=1, M=3, and N=1. A possible structural form of the cell assembly in this application does not constitute any limitation on the protection scope of this application, and may alternatively be another structural from.

For example, the subcell #1 is an N-I-P type subcell, and the subcell #2 is a P-I-N type subcell. Possible structural forms of the cell assembly in the case in which K=1, M=3, and N=1 are not described herein one by one by using examples.

It should be further understood that the foregoing descriptions are merely examples of possible forms of the cell assembly in embodiments of this application, and constitute no limitation on the protection scope of this application. When a value of K, and/or a value of M, and/or a value of N change, a structure of the cell assembly also changes. A specific structure is similar to that shown in FIG. 13 to FIG. 18, and details are not described herein again.

In addition, it should be noted that, when a value of K is greater than 1, it indicates that a quantity of cell strings included in the cell assembly is greater than 1, and the plurality of cell strings may be connected in series and/or in parallel. Embodiments of this application mainly describe a structure of a cell string. A connection between the plurality of cell strings is not described with reference to the accompanying drawings. The connection may be implemented with reference to a current serial connection manner and/or parallel connection manner.

An embodiment of this application further provides an electronic device. The electronic device includes the foregoing cell assembly and a power consumption module. The cell assembly is configured to supply power to the power consumption module.

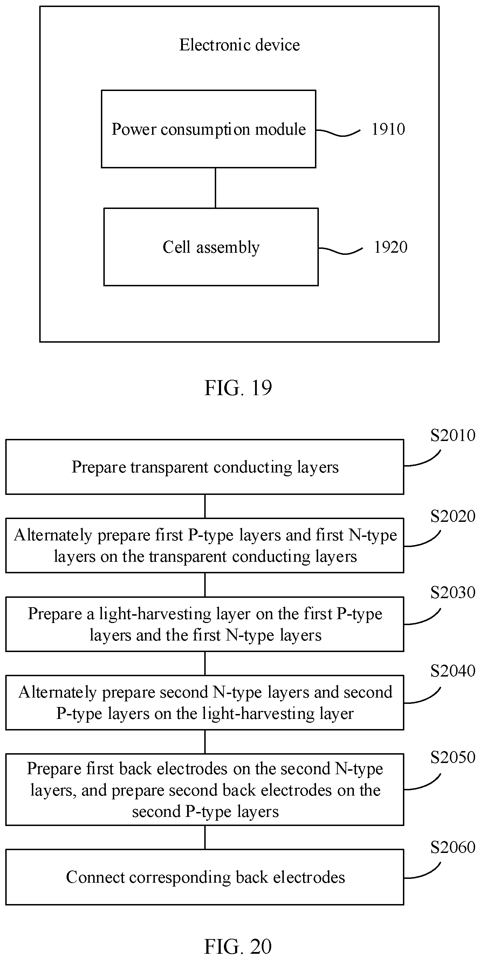

For ease of understanding, the electronic device in this embodiment of this application is briefly described below with reference to FIG. 19.

FIG. 19 is a schematic block diagram of an electronic device according to an embodiment of this application.

It can be seen from FIG. 19 that, the electronic device includes a power consumption module 1910 and a cell assembly 1920. The power consumption module 1910 and the cell assembly 1920 are connected by using a power supply line, to ensure that the cell assembly 1920 can supply power to the power consumption module 1910. For a design of the power supply line, refer to descriptions in the current related technology. This is not limited in this application, provided that the cell assembly 1920 can supply power to the power consumption module 1910.

A specific form of the electronic device is not limited in this embodiment of this application, and may be a handheld device, a vehicle-mounted device, a wearable device, a computing device, a terminal in various forms, a mobile station, a terminal, a software client, or the like. For example, the electronic device may be a water meter, an electricity meter, a sensor, or the like.

In addition, a specific form of the power consumption module 1910 of the electronic device is not limited in this embodiment of this application, and may be any module that needs to use power and that is disposed on the electronic device, for example, a processing module, an input/output module, or a display module of the electronic device.

In an example, the electronic device may be smart glasses, and the electric power module 1910 may be a music output module, a processing module, a display module, or the like of the smart glasses. The cell assembly 1920 may be disposed on a lens of the smart glasses, and the power consumption module 1910 may be disposed on a frame and/or an arm of the smart glasses.

In another example, the electronic device may be a smartphone, and the power consumption module 1910 may be an input/output module, a processing module, a display module, or the like of the smartphone. The cell assembly 1920 may be disposed on a rear cover of the smartphone (for example, on a glass rear cover of the smartphone).

An embodiment of this application further provides two cell assembly preparation methods that can be used to prepare the foregoing cell assembly. For ease of understanding, the following describes in detail a method for preparing a cell assembly in embodiments of this application with reference to the accompanying drawings.

FIG. 20 is a schematic flowchart of a method for preparing a cell assembly according to an embodiment of this application. The method for preparing a cell assembly includes at least some of the following steps.

S2010: Prepare transparent conducting layers.

Specifically, the preparing transparent conducting layers includes:
providing a slot #1 in a transparent conducting layer on an upper layer of a transparent substratein a manner such as laser, where the transparent conducting layers (such as the two transparent conducting layers shown in FIG. 11(a) and FIG. 11(b)) are located on both sides of the slot #1.

Specifically, the providing a slot #1 in a transparent conducting layer on an upper layer of a transparent substrate includes:
cutting a line in the transparent substrate including the transparent conducting layer, and stripping the transparent conducting layer on the cutting line to form the slot #1.

It should be noted that, in this embodiment, description is provided by using an example in which a particular cell string that forms the cell assembly is prepared.

When there are a plurality of cell strings that form the cell assembly, a plurality of lines may be cut in the transparent substrate including the transparent conducting layer, and the transparent conducting layer on the cutting line is separately stripped, to form a plurality of slots #1.

After the transparent conducting layers are formed, first P-type layers and first N-type layers need to be alternately prepared on the transparent conducting layers. The method flow shown in FIG. 20 further includes:
S2020: Alternately prepare the first P-type layers and the first N-type layers on the transparent conducting layers.

Specifically, the first P-type layer and first N-type layer that are adjacent to each other are connected by using a bottom electrode.

For example, a first layer and a second layer are prepared on a first transparent conducting layer in sequence from left to right, a third layer and a fourth layer are prepared on a second transparent conducting layer in sequence from left to right, the first layer and the third layer are the first P-type layers, and the second layer and the fourth layer are the first N-type layers, or the first layer and the third layer are the first N-type layers, and the second layer and the fourth layer are the first P-type layers.

The first transparent conducting layer and the second transparent conducting layer are any two adjacent transparent conducting layers.

For example, a slot #11 is provided between the first layer and the second layer, a slot #12 is provided between the second layer and the third layer, and a slot #13 is provided between the third layer and the fourth layer.

For example, at least one of the slot #11, the slot #12, and the slot #13 is filled with an insulating material.

For example, the P-type layer and the N-type layer are prepared on the first transparent conducting layer in sequence, and the P-type layer and the N-type layer are prepared on the second transparent conducting layer in sequence; or
in another example, the N-type layer and the P-type layer are prepared on the first transparent conducting layer in sequence, and the N-type layer and the P-type layer are prepared on the second transparent conducting layer in sequence.

For example, the first P-type layers and the first N-type layers are alternately prepared on the transparent conducting layers by using a process such as sputtering, evaporation, or coating.

For example, the P-type layers and the N-type layers may be alternately prepared on a plurality of prepared transparent conducting layers. For example, a plurality of P-type layers are first prepared on a plurality of transparent conducting layers respectively, and then a plurality of N-type layers are prepared on the plurality of transparent conducting layers respectively.

Optionally, when a plurality of P-type layers and a plurality of N-type layers are alternately prepared on the transparent conducting layers, slots are provided between the P-type layers and the N-type layers.

After the P-type layers and the N-type layers on the transparent conducting layers are formed, a light-harvesting layer needs to be prepared on the first P-type layers and the first N-type layers. The method flow shown in FIG. 20 further includes:
S2030: Prepare the light-harvesting layer on the first P-type layers and the first N-type layers.

For example, at least one light-harvesting layer is prepared on the first layer, the second layer, the third layer, and the fourth layer.

For example, a same light-harvesting layer is prepared on the first layer, the second layer, the third layer, and the fourth layer; or
a first light-harvesting layer, a second light-harvesting layer, a third light-harvesting layer, and a fourth light-harvesting layer are respectively prepared on the first layer, the second layer, the third layer, and the fourth layer.

A slot #2 is provided between the first light-harvesting layer and the second light-harvesting layer, a slot #3 is provided between the second light-harvesting layer and the third light-harvesting layer, and a slot #4 is provided between the third light-harvesting layer and the fourth light-harvesting layer.

For example, at least one of the slot #2, the slot #3, and the slot #4 is filled with an insulating material.

For example, at least one light-harvesting layer is prepared on the first layer, the second layer, the third layer, and the fourth layer by using a gas-phase process, a liquid-phase process, or the like.

It should be understood that there may be one light-harvesting layer in this embodiment of this application; or
a quantity of light-harvesting layers may be equal to a sum of quantities of the first P-type layers and the first N-type layers that are alternately prepared on the transparent conducting layers; or
the quantity of light-harvesting layers may be greater than 1 and less than the sum of quantities of the first P-type layers and the first N-type layers that are alternately prepared on the transparent conducting layers.

For example, a same light-harvesting layer is prepared on the first layer and the second layer, and another light-harvesting layer is prepared on the third layer and the fourth layer.

Optionally, when the quantity of light-harvesting layers is greater than 1, a slot is provided between every two light-harvesting layers in the plurality of light-harvesting layers.

After the light-harvesting layer is formed, second N-type layers and second P-type layers need to be alternately prepared on the light-harvesting layer. The method flow shown in FIG. 20 further includes:
S2040: Alternately prepare the second N-type layers and the second P-type layers on the light-harvesting layer.

For example, a fifth layer, a sixth layer, a seventh layer, and an eighth layer are prepared on the at least one light-harvesting layer in sequence from left to right.

The fifth layer and the seventh layer are the second P-type layers, and the sixth layer and the eighth layer are the second N-type layers, or the fifth layer and the seventh layer are the second N-type layers, and the sixth layer and the eighth layer are the second P-type layers. In addition, one of the first layer and the fifth layer is the second N-type layer and the other is the second P-type layer, one of the second layer and the sixth layer is the second N-type layer, and the other is the second P-type layer, one of the third layer and the seventh layer is the second N-type layer and the other is the second P-type layer, and one of the fourth layer and the eighth layer is the second N-type layer and the other is the second P-type layer.

For example, the fifth layer, the sixth layer, the seventh layer, and the eighth layer are prepared on the at least one light-harvesting layer in sequence by using a process such as sputtering, evaporation, or coating.

For example, one light-harvesting layer is prepared in S2030, and the fifth layer, the sixth layer, the seventh layer, and the eighth layer are prepared on the light-harvesting layer in sequence from left to right.

A slot #8 is provided between the fifth layer and the sixth layer, a slot #9 is provided between the sixth layer and the seventh layer, and a slot #10 is provided between the seventh layer and the eighth layer.

For example, at least one of the slot #8, the slot #9, and the slot #10 is filled with an insulating material.

After the second P-type layers and the second N-type layers on the light-harvesting layer are formed, back electrodes need to be prepared on the second P-type layers and the second N-type layers. The method flow shown in FIG. 20 further includes:

S2050: Prepare first back electrodes on the second N-type layers, and prepare second back electrodes on the second P-type layers.

For example, the first back electrode, the second back electrode, the first back electrode, and the second back electrode are respectively prepared on the fifth layer, the sixth layer, the seventh layer, and the eighth layer.

A slot #5 is provided between the first back electrode on the fifth layer and the second back electrode on the sixth layer, a slot #6 is provided between the second back electrode on the sixth layer and the first back electrode on the seventh layer, and a slot #7 is provided between the first back electrode on the seventh layer and the second back electrode on the eighth layer.

For example, at least one of the slot #5, the slot #6, and the slot #7 is filled with an insulating material.

For example, the first back electrode, the second back electrode, the first back electrode, and the second back electrode are respectively prepared on the fifth layer, the sixth layer, the seventh layer, and the eighth layer by using magnetron sputtering, evaporation, or another process.

After the back electrodes are formed, corresponding back electrodes need to be connected. The method flow shown in FIG. 20 further includes:
S2060: Connect the corresponding back electrodes.

One bottom electrode, one first P-type layer, one light-harvesting layer, one second N-type layer, and one first back electrode are used to form one first subcell; and
one bottom electrode, one first N-type layer adjacent to the first P-type layer, one light-harvesting layer, one second P-type layer adjacent to the second N-type layer, and one second back electrode are used to form one second subcell, and the bottom electrode of the first subcell and the bottom electrode of the second subcell are an integral structure (or in other words, one bottom electrode is shared).

One first subcell, one second subcell, and one bottom electrode are used to form one cell unit.

An electrical connection between the corresponding back electrodes includes:
connecting the second back electrode in the cell unit to the first back electrode in the other cell unit by using a first electrical conductor.

The at least one cell unit forms one cell group. There are a plurality of cell groups. The electrical connection between the corresponding back electrodes further includes:
connecting a first back electrode on an outermost side of each cell group in the plurality of the cell groups by using a second electrical conductor, and connecting a second back electrode on the outermost side of each cell group in the plurality of cell groups by using the second electrical conductor.

For example, a manner of electrical connection between the corresponding back electrodes includes a manner such as strip welding, evaporation, or magnetron sputtering.

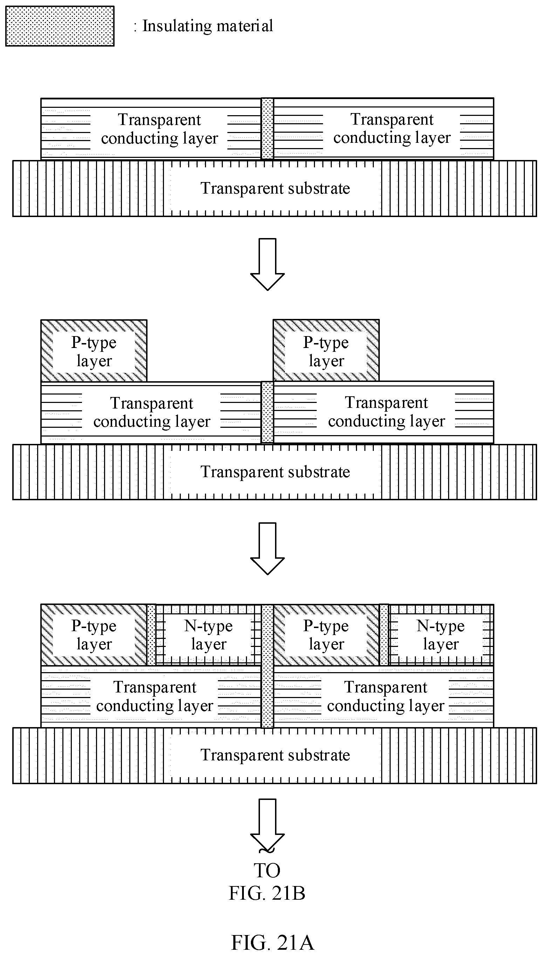

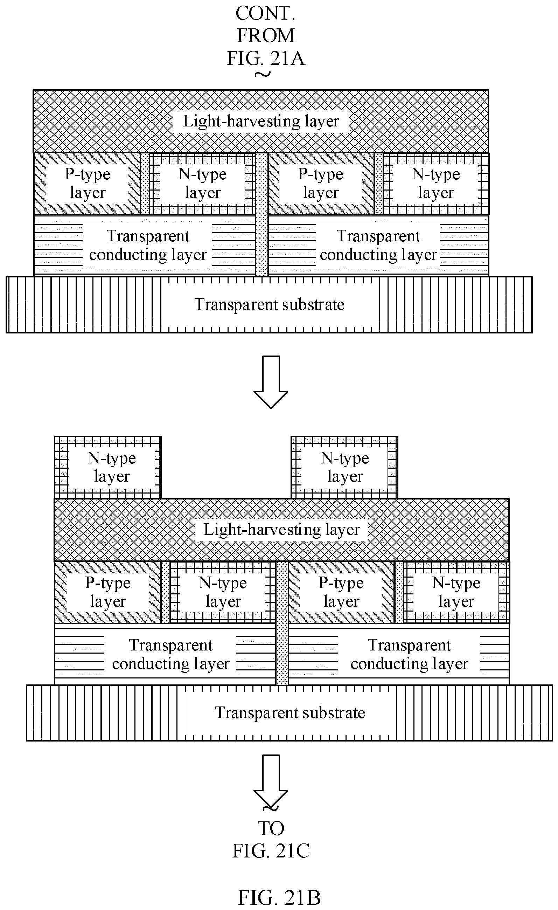

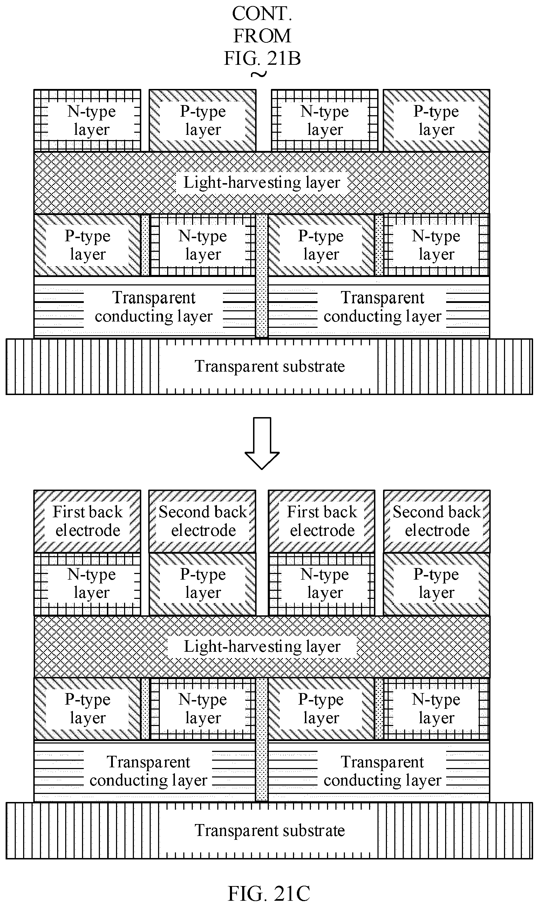

For ease of understanding, the preparation flow shown in FIG. 20 is described with reference to FIG. 21A to FIG. 21C. FIG. 21A to FIG. 21C are a schematic flowchart of preparing a cell assembly according to an embodiment of this application.

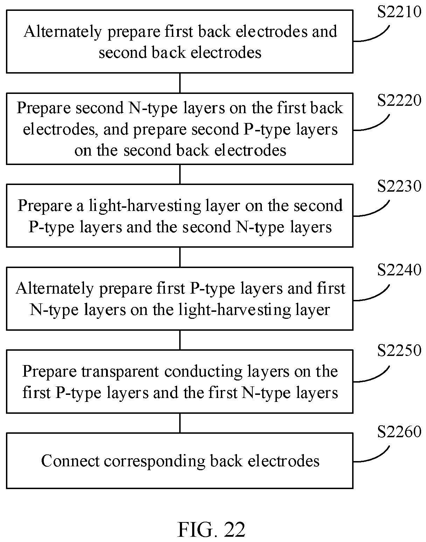

FIG. 22 is a schematic flowchart of another method for preparing a cell assembly according to an embodiment of this application. The method for preparing a cell assembly includes at least some of the following steps.

S2210: Alternately prepare first back electrodes and second back electrodes.

For example, the first first back electrode, the first second back electrode, the second first back electrode, and the second second back electrode are prepared on a substrate.

A slot #5 is provided between the first first back electrode and the first second back electrode, a slot #6 is provided between the first second back electrode and the second first back electrode, and a slot #7 is provided between the second first back electrode and the second second back electrode.

For example, at least one of the slot #5, the slot #6, and the slot #7 is filled with an insulating material.

For example, the first back electrodes and the second back electrodes are alternately prepared on the substrate by using magnetron sputtering, evaporation, or another process.

Optionally, the substrate is cleaned before the first back electrodes and the second back electrodes are alternately prepared on the substrate.

After the back electrodes are successfully prepared, second N-type layers and second P-type layers need to be prepared on the back electrodes. The method flow shown in FIG. 22 further includes:
S2220: Prepare the second N-type layers on the first back electrodes, and prepare the second P-type layers on the second back electrodes.

For example, the second N-type layers are prepared on the first back electrodes, and the second P-type layers are prepared on the second back electrodes by using a process such as sputtering, evaporation, or coating.

After the second P-type layers and the second N-type layers on the back electrodes are formed, a light-harvesting layer needs to be prepared on the second P-type layers and the second N-type layers. The method flow shown in FIG. 22 further includes:
S2230: Prepare the light-harvesting layer on the second P-type layers and the second N-type layers.

Refer to the description in the foregoing S2030. Details are not described herein again.

After the light-harvesting layer is formed, first N-type layers and first P-type layers need to be prepared on the light-harvesting layer. The method flow shown in FIG. 22 further includes:
S2240: Alternately prepare the first P-type layers and the first N-type layers on the light-harvesting layer.

Refer to the description in the foregoing S2040. Details are not described herein again.

After the first P-type layers and the first N-type layers on the light-harvesting layer are formed, transparent conducting layers need to be prepared on the first P-type layers and the first N-type layers. The method flow shown in FIG. 22 further includes:
S2250: Prepare the transparent conducting layers on the first P-type layers and the first N-type layers.

The first P-type layer and first N-type layer that are adjacent to each other on a bottom electrode are connected by using the bottom electrode.

For example, the transparent conducting layers are prepared on the first P-type layers and the first N-type layers by using magnetron sputtering, evaporation, or another process.

After the back electrodes are formed, corresponding back electrodes need to be connected. The method flow shown in FIG. 22 further includes:
S2260: Connect the corresponding back electrodes.

Refer to the description in the foregoing S2060. Details are not described herein again.

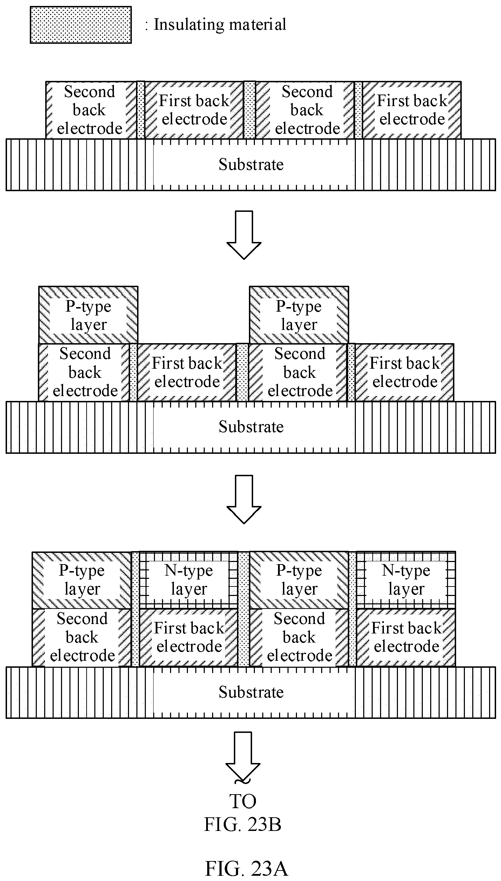

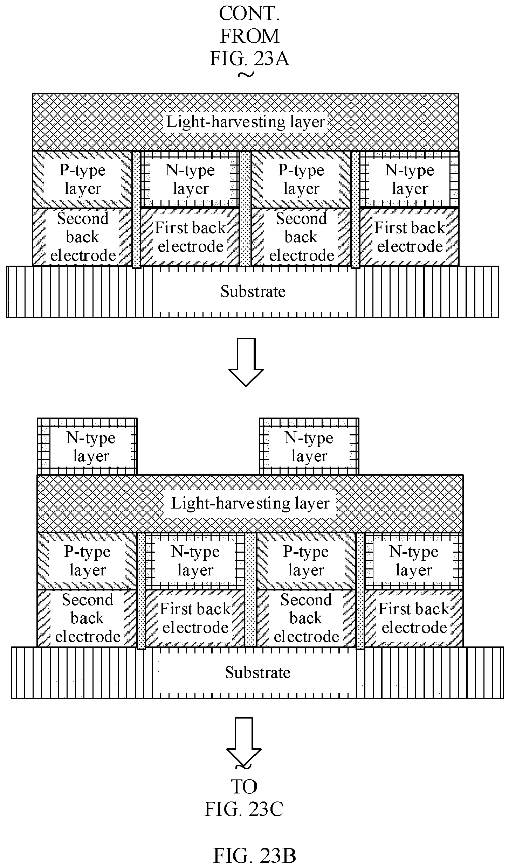

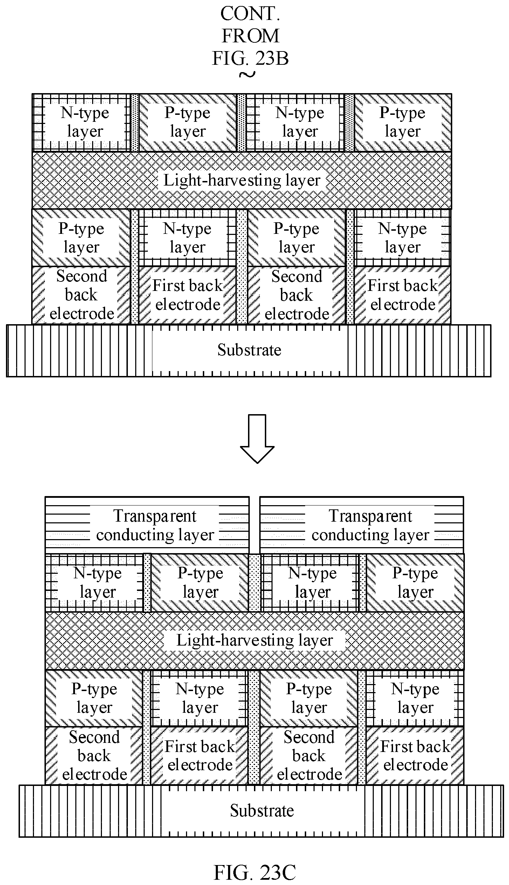

For ease of understanding, the preparation flow shown in FIG. 22 is described with reference to FIG. 23A to FIG. 23C. FIG. 23A to FIG. 23C are a schematic flowchart of preparing another cell assembly according to an embodiment of this application.

The following describes, with reference to a specific example, the cell assembly and a method for preparing the cell assembly provided in the embodiments of this application.

The method for preparing the cell assembly includes the following steps.

### Step 1: Process a transparent substrate.

ITO glass is used as a transparent substrate material, a transparent conducting layer on the ITO glass is cut by using laser, a spacing between cutting lines is 20 mm, and a width of the line is approximately 50 µm. Then, the ITO glass is ultrasonically cleaned for 15 min separately by using a detergent aqueous solution, deionized water, and ethanol, and then the ITO glass is irradiated under ultraviolet light for 10 min after being dried by nitrogen flows.

### Step 2: Prepare a hole transport layer (P-type layer).

The P-type layer is prepared on the transparent conducting layer, and copper phthalocyanine (CuPc) is evaporated in an unshielded region by using a specific mask, to form a CuPc thin film in a specific region of a surface of the transparent conducting layer on the ITO glass, thereby generating a large-area hole transport layer.

### Step 3: Prepare an electron transport layer (N-type layer).

The N-type layer is prepared on the transparent conducting layer, and fullerenes C60 is evaporated in the unshielded region by using another specific mask, to form C60 thin films at intervals in the specific region of the surface of the transparent conducting layer on the ITO glass, thereby forming a large-area electron transport layer. A width of a spacing between the large-area hole transport layer and the large-area electron transport layer is approximately 50 µm, and a spacing slot between transparent conducting layers on the ITO glass and a spacing slot between the P-type layer and the N-type layer are filled with an insulating material: SiO2 nanoparticles for isolation from each other.

### Step 4: Prepare a perovskite active layer.

A layer of 30-nm cesium halogen salt (CsI or CsBr or CsCl) is thermal-evaporated on the prepared electron or hole transport layer, then a layer of 165-nm lead salt (PbI2 or PbBr2 or PbC12) is thermal-evaporated, then a layer of formamidine salt is evaporated on the lead salt, and heating is performed at 160°C for 5 min; and formamidine salt, cesium bromide, and lead iodide react to generate the perovskite active layer.

### Step 5: Prepare an electron transport layer (N-type layer).

The electron transport layer is prepared on the perovskite active layer, the substrate on which processing in the foregoing step 1 to step 4 is performed is placed in a vacuum chamber, and under a 4×10⁻⁴ Pa condition, a layer of C60 with a thickness of 20 nm is evaporated in a specific region of a surface of the perovskite active layer by using an organic evaporation source and by using a specific mask, to form the electron transport layer.

### Step 6: Prepare a hole transport layer (P-type layer).

The hole transport layer is prepared on the perovskite active layer, the substrate on which processing in the foregoing step 1 to step 4 is performed is placed on a blade coater, and a layer of 200-nm spiro is blade-coated at a specific position of a surface, to form the hole transport layer.

### Step 7: Prepare metal back electrodes.

A layer of metal is deposited on the hole transport layer and the electron transport layer that are prepared in step 5 and step 6, to form the metal back electrodes. Specifically, the substrate is fixed in a high-resistance vacuum thermal evaporator by using a mask, after a vacuum degree in the high-resistance vacuum thermal evaporator reaches 10⁻⁵ to 10⁻⁴ Pa, an evaporation boat is heated, and a layer of metal electrodes is deposited on surfaces of the electron transport layer and the hole transport layer at an evaporation rate of 1 Å/s, to form interdigitated back contact electrodes.

### Step 8: Connect the back electrodes.

Finally, preparation of the entire perovskite solar cell assembly is completed through an electrical connection between the corresponding back electrodes (for example, the corresponding back electrodes are electrically connected to implement parallel connection between cell groups, and cell units included in the cell group are connected in series).

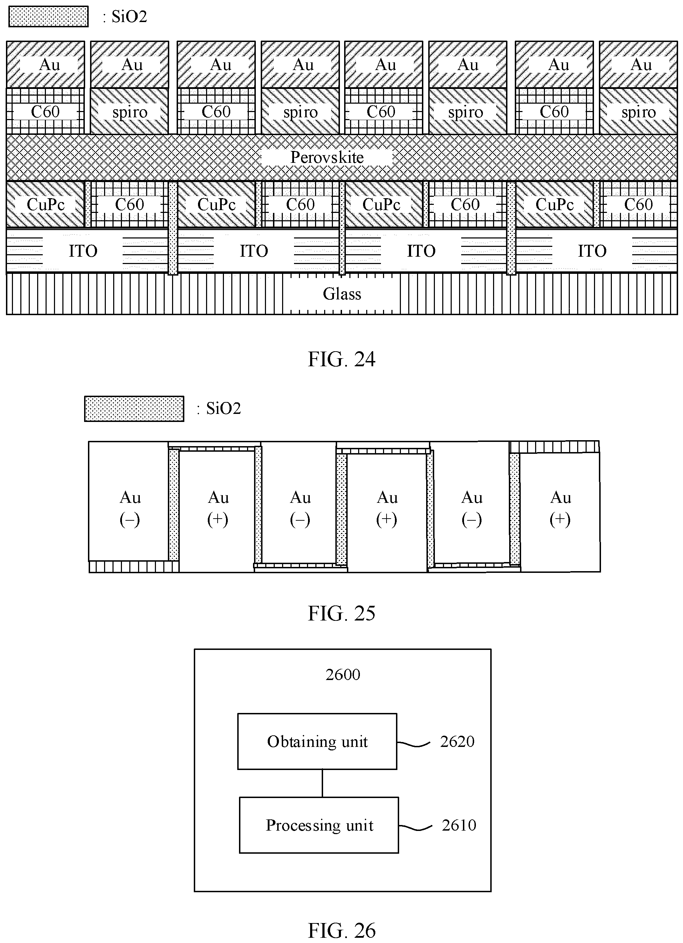

Cross-sectional views of the prepared cell assembly are shown in FIG. 24 and FIG. 25. FIG. 24 is a schematic diagram of a cross section of a perovskite solar cell assembly according to an embodiment of this application. FIG. 25 is a top view of a perovskite solar cell assembly according to an embodiment of this application.

It should be understood that, a device that prepares the cell assembly in the foregoing method embodiment may perform some or all of the steps in the embodiment, and these steps or operations are merely examples. This embodiment of this application may further include performing other operations or variations of various operations.

It may be understood that, in the foregoing method embodiment, the method implemented by the device that prepares the cell assembly may also be implemented by a component (for example, a chip or a circuit) of the device that can be used for preparing the cell assembly.

It should be further understood that, in embodiments of this application, unless otherwise specified or in case of a logical conflict, terms and/or descriptions in different embodiments may be consistent and may be mutually referenced. Technical features in different embodiments may be combined based on an internal logical relationship of the technical features to form a new embodiment.

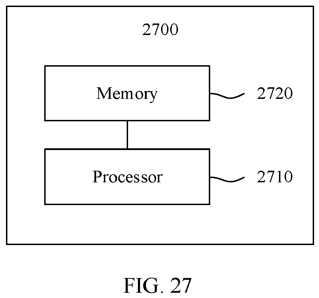

The foregoing describes in detail the methods for preparing a cell assembly in embodiments of this application with reference to FIG. 20 and FIG. 22. The following describes in detail, with reference to FIG. 26 and FIG. 27, an apparatus for preparing a cell assembly provided in embodiments of this application.

FIG. 26 is a schematic diagram of an apparatus 2600 for preparing a cell assembly according to this application. As shown in FIG. 26, the apparatus 2600 includes a processing unit 2610 and an obtaining unit 2620.

Optionally, the obtaining unit 2620 is configured to determine a step that needs to be performed by the processing unit. For example, the obtaining unit 2620 obtains an instruction, where the instruction indicates a step to be performed by the processing unit.

The processing unit 2610 is configured to perform the steps shown in FIG. 20 and FIG. 22.

The apparatus 2600 corresponds to an apparatus for preparing a cell assembly in the method embodiment, and is configured to prepare a cell assembly. The apparatus 2600 may be the apparatus for preparing a cell assembly in the method embodiment, or a chip or a functional module inside the apparatus for preparing a cell assembly in the method embodiment. Corresponding units of the apparatus 2600 are configured to perform corresponding steps performed by the apparatus for preparing the cell assembly in the method embodiments shown in FIG. 20 and FIG. 22.

The processing unit 2610 in the apparatus 2600 is configured to perform processing-related steps corresponding to the apparatus for preparing the cell assembly in the method embodiment.

Optionally, the apparatus 2600 may further include a storage unit. The storage unit is configured to store data and/or signaling. The processing unit 2610 and the obtaining unit 2620 may interact with or be coupled to the storage unit, for example, read or invoke data and/or signaling in the storage unit, so that the method in the foregoing embodiment is performed.

The foregoing units may exist independently, or may be all or partially integrated.

FIG. 27 is a schematic diagram of a structure of an apparatus 2700 for preparing a cell assembly according to an embodiment of this application, and may be configured to implement functions of the foregoing apparatus for preparing a cell assembly.

The apparatus 2700 for preparing a cell assembly includes a processor 2710 and a memory 2720. The memory 2720 stores instructions or a program, and the processor 2710 is configured to execute or invoke the instructions or the program stored in the memory 2720, so that the apparatus 2700 for preparing the cell assembly implements the functions of the apparatus for preparing the cell assembly in the foregoing method for preparing the cell assembly. When the instructions or the program stored in the memory 2720 are or is executed, the processor 2710 is configured to perform the operation performed by the processing unit 2610 in the embodiment shown in FIG. 26.

In some embodiments, the processor 2710 is configured to execute the instructions or the program to perform the steps shown in FIG. 20 and FIG. 22.

A person skilled in the art may understand that for ease of description, FIG. 27 shows only one memory and one processor. There may be a plurality of processors and a plurality of memories in actual user equipment. The memory may also be referred to as a storage medium, a storage device, or the like. This is not limited in the embodiments of this application.

A description of a procedure corresponding to each of the accompanying drawings has a focus. For a part that is not described in detail in a procedure, refer to a related description of another procedure.

All or some of the foregoing embodiments may be implemented by using software, hardware, firmware, or any combination thereof. When software is used for implementing the foregoing embodiments, all or some of the embodiments may be implemented in a form of a computer program product. The computer program product includes one or more computer instructions or computer programs. When the computer instructions or the computer programs are loaded and executed on the computer, the procedure or functions according to some embodiments of this application are all or partially generated. The computer may be a general-purpose computer, a special-purpose computer, a computer network, or other programmable apparatuses. The computer instructions may be stored in a computer-readable storage medium or may be transmitted from one computer-readable storage medium to another computer-readable storage medium. For example, the computer instructions may be transmitted from a website, computer, server, or data center to another website, computer, server, or data center in a wired (for example, infrared, radio, or microwave) manner. The computer-readable storage medium may be any usable medium accessible by a computer, or a data storage device, such as a server or a data center, integrating one or more usable media. The usable medium may be a magnetic medium (for example, a floppy disk, a hard disk, or a magnetic tape), an optical medium (for example, digital versatile disc (DVD)), or a semiconductor medium. The semiconductor medium may be a solid-state drive.

It should be understood that the term "and/or" in this specification describes only an association relationship between associated objects and represents that three relationships may exist. For example, A and/or B may represent the following three cases: only A exists, both A and B exist, and only B exists. A and B may be singular or plural. In addition, the character "/" in this specification usually represents an "or" relationship between the associated objects, or may represent an "and/or" relationship. A specific meaning depends on a context.

In this application, "at least one" refers to one or more, and "a plurality of' refers to two or more. "At least one of the following items (pieces)" or a similar expression thereof means any combination of these items, including any combination of singular items (pieces) or plural items (pieces). For example, at least one of a, b, or c may indicate: a, b, c, a and b, a and c, b and c, or a, b, and c, where a, b, and c may be singular or plural.

It should be understood that, in embodiments of this application, sequence numbers of the foregoing processes do not mean execution sequences. The execution sequences of the processes should be determined based on functions and internal logic of the processes, and should not constitute any limitation to implementation processes of embodiments of this application.

A person of ordinary skill in the art may be aware that, in combination with the examples described in embodiments disclosed in this specification, units and algorithm steps may be implemented by electronic hardware or a combination of computer software and the electronic hardware. Whether the functions are performed by hardware or software depends on particular applications and design constraints of the technical solutions. A person skilled in the art may use different methods to implement the described functions for each particular application, but it should not be considered that the implementation goes beyond the scope of this application.

It may be clearly understood by a person skilled in the art that, for the purpose of convenient and brief descriptions, for a detailed working process of the foregoing systems, apparatuses, and units, refer to a corresponding process in the foregoing method embodiments. Details are not described herein again.

In the several embodiments provided in this application, it should be understood that the disclosed system, apparatus, and method may be implemented in other manners. For example, the described apparatus embodiments are merely examples. For example, the unit division is merely logical function division and may be other division during actual implementation. For example, a plurality of units or components may be combined or integrated into another system, or some features may be ignored or not performed. In addition, the displayed or discussed mutual couplings or direct couplings or communication connections may be implemented through some interfaces. The indirect couplings or communication connections between the apparatuses or units may be implemented in an electronic, a mechanical, or another form.

The units described as separate parts may or may not be physically separate, and parts displayed as units may or may not be physical units, that is, may be located in one position, or may be distributed on a plurality of network units. Some or all of the units may be selected based on actual requirements to achieve the objectives of the solutions in the embodiments. Functional units in the embodiments of this application may be integrated into one processing unit, or each of the units may exist alone physically, or two or more units are integrated into one unit.

When the functions are implemented in the form of a software functional unit and sold or used as an independent product, the functions may be stored in a computer-readable storage medium. Based on such an understanding, the technical solutions of this application essentially, or the part contributing to the conventional technology, or some of the technical solutions may be implemented in a form of a software product. The computer software product is stored in a storage medium, and includes several instructions for instructing a computer device (which may be a personal computer, a server, a network device, or the like) to perform all or some of the steps of the method described in embodiments of this application. The foregoing storage medium includes any medium that can store program code, such as a USB flash drive, a removable hard disk, a read-only memory (read-only memory, ROM), a random access memory (random access memory, RAM), a magnetic disk, or an optical disc.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A cell assembly, comprising:
a first subcell, a second subcell adjacent to the first subcell, and a bottom electrode, wherein both the first subcell and the second subcell comprise a P-type layer, an N-type layer, and a light-harvesting layer located between the P-type layer and the N-type layer, and the P-type layer of the first subcell is connected to the N-type layer of the second subcell by using the bottom electrode.

2. The cell assembly according to claim 1, wherein
the first subcell further comprises a first back electrode, and the second subcell further comprises a second back electrode, wherein the N-type layer of the first subcell is connected to the first back electrode, and the P-type layer of the second subcell is connected to the second back electrode.

3. The cell assembly according to claim 2, wherein
there are a plurality of first subcells, a plurality of second subcells, and a plurality of bottom electrodes; one first subcell, one second subcell, and one bottom electrode are used to form one cell unit; at least one cell unit forms one cell group; there are a plurality of cell groups; and the plurality of cell groups are connected in parallel.

4. The cell assembly according to claim 3, wherein that the plurality of cell groups are connected in parallel comprises:
a first back electrode on an outermost side of each cell group in the plurality of the cell groups is connected by using a second electrical conductor, and a second back electrode on the outermost side of each cell group in the plurality of cell groups is connected by using the second electrical conductor.

5. The cell assembly according to claim 3 or 4, wherein the cell group comprises a plurality of cell units; and the second back electrode in one of two adjacent cell units in the plurality of cell units is connected to the first back electrode in the other cell unit by using a first electrical conductor.

6. The cell assembly according to any one of claims 2 to 5, wherein
a first slot is provided between the first subcell and the second subcell, and the first slot is provided between the first back electrode of the first subcell and the second back electrode of the second subcell, between the N-type layer of the first subcell and the P-type layer of the second subcell, between the P-type layer of the first subcell and the N-type layer of the second subcell, and between the light-harvesting layer of the first subcell and the light-harvesting layer of the second subcell.

7. The cell assembly according to any one of claims 2 to 5, wherein the light-harvesting layer of the first subcell and the light-harvesting layer of the second subcell are an integral structure; and
a first slot is provided between the first subcell and the second subcell, and the first slot is provided between the first back electrode of the first subcell and the second back electrode of the second subcell, between the N-type layer of the first subcell and the P-type layer of the second subcell, and between the P-type layer of the first subcell and the N-type layer of the second subcell.

8. The cell assembly according to any one of claims 3 to 7, wherein
a second slot is provided between two adjacent cell units, and the second slot is located between a first back electrode of a third subcell and the second back electrode of the second subcell, between an N-type layer of the third subcell and the P-type layer of the second subcell, between a P-type layer of the third subcell and the N-type layer of the second subcell, between a light-harvesting layer of the third subcell and the light-harvesting layer of the second subcell, and between a first bottom electrode and a second bottom electrode; and
the third subcell and the second subcell are subcells that are adjacent in two subcells separately comprised in the two adjacent cell units, and the first bottom electrode and the second bottom electrode are bottom electrodes separately comprised in the two adjacent cell units.

9. The cell assembly according to claim 6 or 8, wherein the light-harvesting layer is made from single-crystal perovskite.

10. The cell assembly according to any one of claims 3 to 7, wherein
a second slot is provided between two adjacent cell units, and the second slot is located between a first back electrode of a third subcell and the second back electrode of the second subcell, between an N-type layer of the third subcell and the P-type layer of the second subcell, between a P-type layer of the third subcell and the N-type layer of the second subcell, and between a first bottom electrode and a second bottom electrode; and
the third subcell and the second subcell are subcells that are adjacent in two subcells separately comprised in the two adjacent cell units, and the first bottom electrode and the second bottom electrode are bottom electrodes separately comprised in the two adjacent cell units.

11. The cell assembly according to claim 7 or 10, wherein the light-harvesting layer is made from polycrystalline perovskite.

12. The cell assembly according to any one of claims 6 to 11, wherein an insulating material is filled in the first slot and/or the second slot.

13. A method for preparing a cell assembly, comprising:
preparing a bottom electrode;
alternately preparing a first P-type layer and a first N-type layer on the bottom electrode;
preparing a light-harvesting layer on the first P-type layer and the first N-type layer, wherein
the first P-type layer and first N-type layer that are adjacent to each other on the bottom electrode are connected by using the bottom electrode;
one bottom electrode, one first P-type layer, and one light-harvesting layer are used to form one first subcell; and
one bottom electrode, one first N-type layer adjacent to the first P-type layer, and one light-harvesting layer are used to form one second subcell, and the bottom electrode of the first subcell and the bottom electrode of the second subcell are an integral structure.

14. The method according to claim 13, wherein the method further comprises:
alternately preparing a second N-type layer and a second P-type layer on the light-harvesting layer; and
preparing a first back electrode on the second N-type layer and preparing a second back electrode on the second P-type layer, wherein
the second N-type layer is connected to the first back electrode, the second P-type layer is connected to the second back electrode,
one second N-type layer and one first back electrode are used to form one first subcell, and
one second P-type layer adjacent to the second N-type layer and one second back electrode are used to form one second subcell.

15. A method for preparing a cell assembly, comprising:
preparing a light-harvesting layer;
alternately preparing a first P-type layer and a first N-type layer on the light-harvesting layer;
preparing a bottom electrode on the first P-type layer and the first N-type layer, wherein
the first P-type layer and first N-type layer that are adjacent to each other on the bottom electrode are connected by using the bottom electrode;
one bottom electrode, one first P-type layer, and one light-harvesting layer are used to form one first subcell; and
one bottom electrode, one first N-type layer adjacent to the first P-type layer, and one light-harvesting layer are used to form one second subcell, and the bottom electrode of the first subcell and the bottom electrode of the second subcell are an integral structure.

16. The method according to claim 15, wherein before the preparing a light-harvesting layer, the method further comprises:
alternately preparing a first back electrode and a second back electrode;
preparing a second N-type layer on the first back electrode, and preparing a second P-type layer on the second back electrode, wherein
the second N-type layer is connected to the first back electrode, the second P-type layer is connected to the second back electrode,
one second N-type layer and one first back electrode are used to form one first subcell, and
one second P-type layer adjacent to the second N-type layer and one second back electrode are used to form one second subcell.

17. The method according to any one of claims 13 to 16, wherein one first subcell, one second subcell, and one bottom electrode are used to form one cell unit, at least one cell unit forms one cell group, there are a plurality of cell groups; and the method further comprises:
connecting a first back electrode on an outermost side of each cell group in the plurality of the cell groups by using a second electrical conductor, and connecting a second back electrode on the outermost side of each cell group in the plurality of cell groups by using the second electrical conductor.

18. The method according to claim 17, wherein the cell group comprises a plurality of cell units, and the method further comprises:
connecting the second back electrode in one of two adjacent cell units in the plurality of cell units to the first back electrode in the other cell unit by using a first electrical conductor.

19. The method according to claim 17 or 18, wherein the method further comprises:
providing a first slot between the first back electrode of the first subcell and the second back electrode of the second subcell, between an N-type layer of the first subcell and a P-type layer of the second subcell, between a P-type layer of the first subcell and an N-type layer of the second subcell, and between a light-harvesting layer of the first subcell and a light-harvesting layer of the second subcell.

20. The method according to claim 17 or 18, wherein the light-harvesting layer of the first subcell and the light-harvesting layer of the second subcell are an integral structure; and the method further comprises:
providing a first slot between the first back electrode of the first subcell and the second back electrode of the second subcell, between an N-type layer of the first subcell and a P-type layer of the second subcell, and between a P-type layer of the first subcell and an N-type layer of the second subcell.

21. The method according to any one of claims 17 to 20, wherein the method further comprises:
providing a second slot between a first back electrode of a third subcell and the second back electrode of the second subcell, between an N-type layer of the third subcell and the P-type layer of the second subcell, between a P-type layer of the third subcell and the N-type layer of the second subcell, between a light-harvesting layer of the third subcell and the light-harvesting layer of the second subcell, and between a first bottom electrode and a second bottom electrode, wherein
the third subcell and the second subcell are subcells that are adjacent in two subcells separately comprised in the two adjacent cell units, and the first bottom electrode and the second bottom electrode are bottom electrodes separately comprised in the two adjacent cell units.

22. The method according to any one of claims 17 to 20, wherein the light-harvesting layers of the two adjacent cell units are an integral structure, and the method further comprises:
providing a second slot between a first back electrode of a third subcell and the second back electrode of the second subcell, an N-type layer of the third subcell and the P-type layer of the second subcell, between a P-type layer of the third subcell and the N-type layer of the second subcell, and between a first bottom electrode and a second bottom electrode, wherein
the third subcell and the second subcell are subcells that are adjacent in two subcells separately comprised in the two adjacent cell units, and the first bottom electrode and the second bottom electrode are bottom electrodes separately comprised in the two adjacent cell units.

23. The method according to any one of claims 19 to 22, wherein the method further comprises:
filling an insulating material in the first slot and/or the second slot.

24. An electronic device, comprising a power consumption module and the cell assembly according to any one of claims 1 to 12, or comprising a cell assembly prepared by using the preparation method according to any one of claims 13 to 23, wherein the cell assembly is used to supply power to the power consumption module.
